# EUROPEAN PATENT APPLICATION

(11) **EP 4 195 904 A1**
(43) Date of publication of application: **14.06.2023**
(21) Application number: 22209206.6
(22) Date of filing: 23.11.2022
(51) Int. Cl.: H10K 59/65, G06V 40/16

(54) **DISPLAY DEVICE**

(30) Priority: 07.12.2021 KR 20210173566
(71) Applicant: LG Display Co., Ltd., SEOUL, 07336 (KR)
(72) Inventor: LEE, Guen Sik, 10845 Paju-si (KR); KIM, Tae Hun, 10845 Paju-si (KR); JIN, Seung Tae, 10845 Paju-si (KR)
(74) Representative: Beal, James Michael

(57) **Abstract**

A display panel can include a plurality of subpixels disposed on a substrate and configured to display an image; a plurality of light-emitting elements disposed on the substrate and configured to emit light; and a plurality of light-receiving elements disposed on the substrate and configured to receive reflected light based on the light emitted by the plurality of light-emitting elements, in which the plurality of light-emitting elements or the plurality of light-receiving elements are disposed between the plurality of subpixels. The plurality of light-emitting elements can emit infrared laser light and the plurality of light-receiving elements are configured to generate a three-dimensional map for recognizing a face of a user based on the infrared laser light emitted by the plurality of light-emitting elements.

## Description

### CROSS-REFERENCE TO RELATED APPLICATION

This application claims priority to and the benefit of Korean Patent Application No. 10-2021-0173566, filed in the Republic of Korea on December 07, 2021.

### BACKGROUND OF THE DISCLOSURE

### Field of the Invention

The embodiments of the present disclosure relate to a display device.

### Discussion of Related Art

Electroluminescence display devices can be classified into inorganic light-emitting display devices and organic light-emitting display devices depending on materials of an emission layer.

An active-matrix-type organic light-emitting display device includes an organic light-emitting diode (OLED) that emits light by itself (e.g., no backlight needed) and has advantages of a quick response time, high light emission efficiency, high luminance, and a wide viewing angle. The organic light-emitting display device has OLEDs formed in each pixel. The organic light-emitting display device may represent a black grayscale as perfect black (e.g., true black, since individual subpixels can be completely turned off) as well as having a quick response time, high light emission efficiency, high luminance, and a wide viewing angle, and thus has an excellent contrast ratio and color gamut.

Multimedia functions of a mobile terminal have been improved. For example, a camera is basically built in a smart phone and the resolution of the camera is increasing to a about the same level as a stand-alone, existing digital camera. However, a front camera of the smart phone can limit the design of a screen, thereby making it difficult to design the screen. In order to reduce the space occupied by the camera, a screen design including a notch or a punch hole has been adopted in the smart phone, but it can be difficult to implement a full-screen display because a screen size can be still limited due to the camera (e.g., a notch or black hole in the display screen is often despised by users).

In order to implement a full-screen display, a method of preparing an image capturing area in which low-resolution pixels are disposed in a screen of a display panel, and disposing an electronic component, such as a camera and various sensors, at a position under the display panel, which faces the image capturing area, has been proposed.

### SUMMARY OF THE DISCLOSURE

Accordingly, the present disclosure is directed to providing a display panel or a display device that substantially obviates one or more issues due to limitations and disadvantages of the related art.

An invention is set out in the independent claim. An aspect of the present disclosure is directed to providing a display panel for a display device, in which the display panel includes a plurality of subpixels disposed on a substrate and configured to display an image, one or more light-emitting elements disposed on the substrate and configured to emit light, and one or more light-receiving elements disposed on the substrate and configured to receive reflected light based on the light emitted by the one or more light-emitting elements, in which the one or more light-emitting elements or the one or more light-receiving elements are disposed between the plurality of subpixels.

According to an aspect of the present disclosure, the light emitted by the one or more light-emitting elements is infrared laser light.

According to another aspect of the present disclosure, the one or more light-receiving elements are configured to generate a three-dimensional map for recognizing a face of a user based on the infrared laser light emitted by the one or more light-emitting elements.

According to an aspect of the present disclosure, the one or more light-emitting elements and the one or more light-receiving elements are disposed between the plurality of subpixels.

According to an aspect of the present disclosure, the one or more light-emitting elements or the one or more light-receiving elements are disposed on a same layer as the plurality of subpixels.

According to another aspect of the present disclosure, the one or more light-emitting elements or the one or more light-receiving elements are disposed on a different layer than the plurality of subpixels.

According to an aspect of the present disclosure, the display panel can further include a first display area including a first portion of the plurality of subpixels; a second display area including a second portion of the plurality of subpixels, in which the one or more light-emitting elements or the one or more light-receiving elements are only included in the second display area and are absent from the first display area.

According to another aspect of the present disclosure, the first portion of the plurality of subpixels in the first display area has a density that is different than a density of the second portion of the plurality of subpixels in the second display area.

According to an aspect of the present disclosure, the first portion of the plurality of subpixels in the first display area has a density that is same as a density of the second portion of the plurality of subpixels in the second display area. Also, at least some of the plurality of subpixels in the second display area have a size that is smaller than all pixels in the first display area.

According to another aspect of the present disclosure, the display panel can further include at least one diffraction pattern disposed over the one or more light-emitting elements. Also, the display panel can include at least one first lens disposed over the one or more light-emitting elements, in which the at least one first lens is disposed between the at least one diffraction pattern and the one or more light-emitting elements.

According to an aspect of the present disclosure, the one or more light-emitting elements are disposed under the substrate, and the plurality of subpixels are disposed between at least one diffraction pattern and the one or more light-emitting elements. Also, the display panel can include at least one second lens disposed over the one or more light-receiving elements.

According to another aspect of the present disclosure, the at least one second lens includes at least two second lenses shifted in opposite directions relative to corresponding ones of the one or more light-receiving elements for adjusting a focus of the one or more light-receiving elements. Also, the one or more light-emitting elements or the one or more light-receiving elements can be disposed in a grid arrangement or an array arrangement.

According to an aspect of the present disclosure, the one or more light-emitting elements are disposed in a first area of the display panel, and the one or more light-receiving elements are disposed in a second area of the display panel spaced apart from the first area of the display panel. Also, the one or more light-emitting elements and the one or more light-receiving elements can be alternatingly disposed throughout the display panel.

According to another aspect of the present disclosure, the display panel can further include an anode and a cathode, each of the plurality of subpixels being connected between the anode and the cathode, in which the one or more light-emitting elements or the one or more light-receiving elements are disposed under one or more holes in the cathode.

According to an aspect of the present disclosure, the light emitted by the one or more light-emitting elements passes through a diffraction pattern and is divided into a zero-order beam and a first-order beam, the one or more light-receiving elements is configured to receive the first-order beam, and a diffraction ratio of the zero-order beam and the first-order beam is in a range of 1:2 to 1:7.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

It is to be understood that both the foregoing general description and the following detailed description of the present disclosure are explanatory and are intended to provide further examples and explanation of the disclosure as claimed.

### BRIEF DESCRIPTION OF THE DRAWINGS

The above and other objects, features, and advantages of the present disclosure will become more apparent to those of ordinary skill in the art by describing example embodiments thereof in detail with reference to the accompanying drawings, in which:
FIG. 1 is a conceptual diagram of a display device according to an embodiment of the present disclosure;
FIG. 2 is a cross-sectional view schematically illustrating a display panel according to an embodiment of the present disclosure;
FIG. 3 is a view illustrating a face image detection method as a comparative example;
FIG. 4 is a view illustrating a face image detection method according to an embodiment of the present disclosure;
FIGS. 5a to 5c are views illustrating a second display area disposed at various positions according to embodiments of the present disclosure;
FIG. 6 is a view illustrating a pixel arrangement in a first display area according to an embodiment of the present disclosure;
FIG. 7 is a view illustrating pixels and light-transmitting areas of a second display area according to an embodiment of the present disclosure;
FIGS. 8a to 8d are views illustrating various pixel structures in which a plurality of light-emitting elements are disposed according to embodiments of the present disclosure;
FIG. 9 is a view illustrating a state in which light emitted from the plurality of light-emitting elements is diffracted by a diffraction pattern according to an embodiment of the present disclosure;
FIG. 10 is a cross-sectional view of the light-emitting element according to an embodiment of the present disclosure;
FIG. 11 is a view illustrating a structure in which the plurality of light-emitting elements are disposed inside a display panel according to an embodiment of the present disclosure;
FIG. 12 is a view illustrating a structure in which a lens is disposed on an upper portion of each of the plurality of light-emitting elements according to an embodiment of the present disclosure;
FIG. 13 is a view illustrating a structure in which the lens is disposed on an upper portion of the light-emitting element according to an embodiment of the present disclosure;
FIG. 14 is a conceptual diagram of a display device according to another embodiment of the present disclosure;
FIG. 15 is a view illustrating a structure in which a plurality of light-receiving elements receive reflected light according to an embodiment of the present disclosure;
FIG. 16 is a view illustrating a state in which the plurality of light-receiving elements are disposed between pixels according to an embodiment of the present disclosure;
FIGS. 17a to 17d are views illustrating various pixel structures in which the plurality of light-receiving elements are disposed according to embodiments of the present disclosure;
FIG. 18 is a view illustrating a state in which a light-receiving module is disposed below a display panel according to an embodiment of the present disclosure;
FIG. 19 is a view illustrating a process of acquiring a face image through the plurality of light-receiving elements according to an embodiment of the present disclosure;
FIG. 20 is a view illustrating a state in which an optical axis is inclined according to a position of the light-receiving element according to an embodiment of the present disclosure;
FIG. 21 is a view illustrating a state in which a sensing circuit is divided for each of a plurality of sensing areas according to an embodiment of the present disclosure;
FIGS. 22a and 22b are views illustrating a process of synthesizing a plurality of divided images according to embodiments of the present disclosure;
FIG. 23 is a conceptual diagram of a display device according to another embodiment of the present disclosure;
FIG. 24 is a first modified example of FIG. 23 according to an embodiment of the present disclosure;
FIG. 25 is a second modified example of FIG. 23 according to an embodiment of the present disclosure;
FIG. 26 is a view illustrating a structure in which the plurality of light-receiving elements are disposed on the panel according to an embodiment of the present disclosure;
FIG. 27 is a view illustrating a structure in which the plurality of light-emitting elements are disposed on the panel according to an embodiment of the present disclosure;
FIG. 28 is a block diagram illustrating a display panel and a display panel driving unit according to an embodiment of the present disclosure;
FIG. 29 is a block diagram schematically illustrating a configuration of a driver integrated circuit (IC) according to an embodiment of the present disclosure;
FIG. 30 is a cross-sectional view illustrating a cross-sectional structure of a pixel area in detail in a display panel according to an embodiment of the present disclosure;
FIG. 31 illustrates a cross-sectional structure of the pixel area and a light-transmitting area according to an embodiment of the present disclosure;
FIG. 32 is a first modified example of FIG. 31 according to an embodiment of the present disclosure; and
FIG. 33 is a second modified example of FIG. 31 according to an embodiment of the present disclosure.

### DETAILED DESCRIPTION OF THE EMBODIMENTS

Advantages and features of the present disclosure and implementation methods thereof will be clarified through the following embodiments described with reference to the accompanying drawings. However, the present disclosure is not limited to the embodiments described below and may be embodied with a variety of different modifications. The embodiments are merely provided to allow those skilled in the art to completely understand the scope of the present disclosure, and the present disclosure is defined only by the scope of the claims.

The figures, dimensions, ratios, angles, numbers, and the like disclosed in the drawings for describing the embodiments of the present disclosure are merely illustrative and are not limited to matters shown in the present disclosure. Like reference numerals refer to like components throughout. Further, in describing the present disclosure, detailed descriptions of well-known technologies will be omitted when it is determined that they may unnecessarily obscure the gist of the present disclosure.

Terms such as "including," "having," and "composed of' used herein are intended to allow other elements to be added unless the terms are used with the term "only." Any references to the singular may include the plural unless expressly stated otherwise.

Components are interpreted to include an ordinary error range even if not expressly stated.

For description of a positional relationship, for example, when the positional relationship between two parts is described as "on," "above," "below," "over," "under," and "next to," etc., one or more parts may be interposed therebetween unless the term "immediately" or "directly" is used in the expression.

In the description of embodiments, the terms "first," "second," and the like may be used herein to describe various components, the components are not limited by the terms. These terms are used only to distinguish one component from another. Therefore, a first component discussed below could be termed a second component without departing from the teachings of the present disclosure.

Like reference numerals refer to like components throughout the specification.

The features of various embodiments may be partially or entirely bonded to or combined with each other. The embodiments may be interoperated and performed in technically various ways and may be carried out independently of or in association with each other.

Hereinafter, various embodiments of the present disclosure will be described in detail with reference to the accompanying drawings.

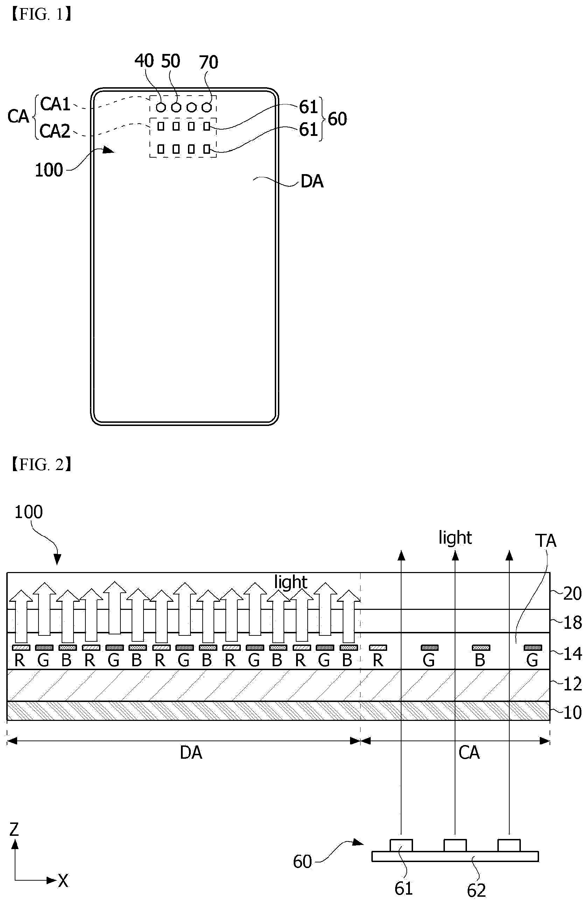

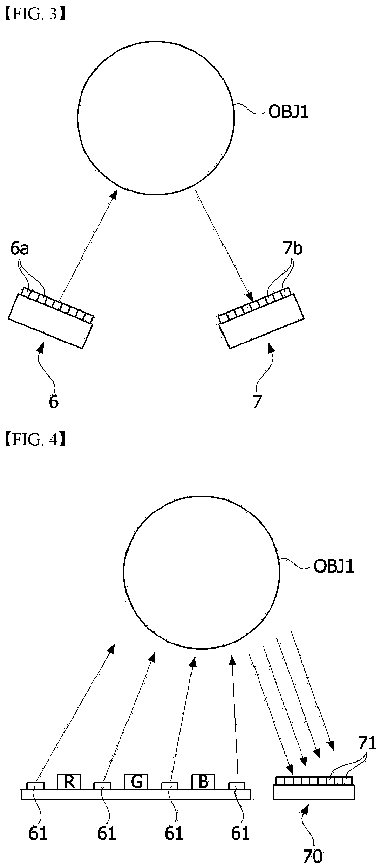

FIG. 1 is a conceptual diagram of a display device according to a first embodiment of the present disclosure. FIG. 2 is a cross-sectional view schematically illustrating a display panel according to the first embodiment of the present disclosure. FIG. 3 is a view illustrating a face image detection method as a comparative example. FIG. 4 is a view illustrating a face image detection method according to an embodiment of the present disclosure.

Referring to FIG. 1, the display device can include a display panel 100 and a case, and a front surface of the display panel 100 can be configured as a display area. Thus, a full-screen display can be implemented.

The display area can include a first display area DA and a second display area CA. The first display area DA is an area in which sensors are not disposed, and the second display area CA can be divided into areas in which a plurality of sensors 40, 50, 60, and 70 are disposed. The plurality of sensors 40, 50, 60, and 70 can be components of various sensors.

The first display area DA and the second display area CA can all output images and have the same resolution. However, the present disclosure is not necessarily limited thereto, and the resolution of a plurality of second pixels disposed in the second display area CA can be lower than the resolution (or density) of a plurality of first pixels disposed in the first display area DA. A relatively large amount of light can be injected into the sensors disposed in the second display area CA by the extent to which the resolution (or density) of the plurality of second pixels disposed in the second display area CA is lowered. As used herein, the density of pixels/subpixels may refer to the number of pixels/subpixels per unit area.

Since the second display area CA is an area that overlaps the plurality of sensors 40, 50, 60, and 70, an area of the second display area CA can be smaller than that of the first display area DA outputting a majority of the image. The second display area CA is illustrated as being disposed on an upper end of the display device, but the present disclosure is not necessarily limited thereto. The position and area of the second display area CA can be variously modified.

The plurality of sensors 40, 50, 60, and 70 can include at least one of an image sensor, a proximity sensor, an illumination sensor, a gesture sensor, a motion sensor, a fingerprint recognition sensor, and a biometric sensor. As an example, a first sensor can be an illumination sensor and a second sensor can be an image sensor configured to capture an image or a video, but the present disclosure is not necessarily limited thereto.

The second display area CA can include a first divided area CA1 in which a plurality of sensors 40, 50, and 70 are disposed, and a second divided area CA2 in which a light-emitting module 60 is disposed. The light-emitting module 60 can include a plurality of light-emitting elements 61 distributed and disposed in the second divided area CA2. The plurality of light-emitting elements 61 can be laser light-emitting elements that emit infrared light, but the present disclosure is not necessarily limited thereto.

The first divided area CA1 and the second divided area CA2 can have the same resolution, but the present disclosure is not necessarily limited thereto. As an example, the resolution of the first divided area CA1 can be lower than that of the second divided area CA2, or vice versa. The first divided area CA1 has a camera disposed therein and thus can have a reduced number of pixels in order to increase light transmittance, whereas the second divided area CA2 can have the same number of pixels as the first display area because the plurality of light-emitting elements 61 are manufactured to be small, and distributed and disposed between the pixels.

Referring to FIG. 2, the first display area DA and the second display area CA can include a pixel array in which pixels, to which pixel data is written, are disposed. As described above, the number of pixels per unit area (hereinafter, referred to as "pixels per inch (PPI)") of the second display area CA can be the same as the first display area DA, but can be lower than that of the first display area DA in order to ensure the light transmittance of the second display area CA.

The pixel array of the first display area DA can include a pixel area in which a plurality of pixel groups having a high PPI are disposed. The pixel array of the second display area CA can include a pixel area in which a plurality of pixel groups having a relatively low PPI are disposed by being spaced apart from each other by light-transmitting areas TA. In the second display area CA, external light can pass through the display panel 100 through the light-transmitting areas TA having high light transmittance and can be received by a sensor placed below the display panel 100. In addition, the light irradiated from the plurality of light-emitting elements 61 can be emitted to the outside through the light-transmitting areas TA (e.g., an array of infra-red laser lights can be emitted onto a user's face for facial recognition).

Each of the pixels of the first display area DA and the second display area CA can include sub-pixels having different colors to implement a color of an image. The sub-pixels can include red, green, and blue sub-pixels. Also, the pixel group can further include a white sub-pixel. Each of the sub-pixels can include a pixel circuit unit and an organic light-emitting diode (OLED).

The display panel 100 can include a circuit layer 12 disposed on a substrate 10, and an element layer 14 disposed on the circuit layer 12. A polarizing plate 18 can be disposed on the element layer 14, and a cover glass 20 can be disposed on the polarizing plate 18.

The circuit layer 12 can include a pixel circuit connected to lines, such as data lines, gate lines, power lines, and the like, a gate driving unit connected to the gate lines, and the like.

The circuit layer 12 can include a circuit element, such as a transistor implemented as a thin-film transistor (TFT), a capacitor, and the like. The lines and circuit elements of the circuit layer 12 can be implemented with a plurality of insulating layers, two or more metal layers separated from each other with the insulating layers therebetween, and an active layer including a semiconductor material.

The element layer 14 can include an OLED driven by the pixel circuit. The OLED can include an organic compound layer formed between an anode and a cathode.

The organic compound layer can include a hole injection layer HIL, a hole transport layer HTL, an emission layer EML, an electron transport layer ETL, and an electron injection layer EIL, but the present disclosure is not limited thereto.

When a voltage is applied to the anode and the cathode of the OLED, holes passing through the hole transport layer HTL and electrons passing through the electron transport layer ETL move to the emission layer EML to create excitons, and thus visible light can be emitted from the emission layer EML

The element layer 14 can further include a color filter array disposed on the pixels that selectively transmit light of red, green, and blue wavelengths.

The element layer 14 can be covered by a protective film, and the protective film can be covered by an encapsulation layer. The protective film and the encapsulation layer can have a structure in which organic films and inorganic films are alternately stacked. The inorganic films can block the penetration of moisture and/or oxygen. The organic films can planarize a surface of the inorganic film. When the organic films and the inorganic films are stacked in multiple layers (e.g., an organic film disposed between two inorganic films, etc.), the penetration of moisture/oxygen affecting the element layer 14 can be effectively blocked since a movement path of the moisture or oxygen is increased in length as compared with a single layer.

The polarizing plate 18 can be disposed on the element layer 14. The polarizing plate 18 can improve outdoor visibility of the display device. The polarizing plate 18 can reduce the reflection of light incident on a surface of the display panel 100 and block the light reflected from metal of the circuit layer 12, thereby improving the brightness of the pixels. The polarizing plate 18 can be implemented as a polarizing plate to which a linear polarizing plate and a phase retardation film are bonded, or a circular polarizing plate.

In the second display area CA, the plurality of sensors can be disposed below a screen of the display panel 100. Alternatively, the plurality of sensors can be embedded within a screen of the display panel, such as being disposed on a same layer as the subpixels or in a layer nearby the subpixels.

An infrared sensor can include the light-emitting module 60 configured to irradiate infrared light to the front surface of the display panel 100, and a light-receiving module 70 configured to receive reflected light (e.g., bounced off of a user's face or a three-dimensional object). The light-emitting module 60 can include the plurality of light-emitting elements 61. Each of the plurality of light-emitting elements 61 can be a laser light-emitting element that emits infrared light (e.g., low power laser light that is safe for a user's eyes and face). Using this, a user's face can be detected.

Referring to FIG. 3, in the face image detection method of the comparative example, a three-dimensional feature map can be generated by irradiating a plurality of infrared lights from a light-emitting array 6a of an infrared projector 6 and receiving light reflected from a face of a user OBJ1 by a light-receiving array 7b of an infrared camera 7. Through this process, the user's face can be recognized. However, there is a problem in that such a structure requires a separate space in which the infrared projector 6 configured to irradiate infrared light and the infrared camera 7 are disposed, and thus, there is a problem in that a display area decreases by as much as an area occupied by the infrared projector 6 and the infrared camera 7.

Referring to FIG. 4, in the light-emitting module 60 according to the embodiment, the plurality of light-emitting elements 61 are separated each other and disposed between pixels (R, G, and B) and thus may not occupy a separate space. For example, the plurality of light-emitting elements 61 and the pixels (R, G, and B) can be disposed on a same layer. Alternatively, the plurality of light-emitting elements 61 and the pixels (R, G, and B) can disposed on different layers that are nearby each other and overlapping. That is, the number and/or size of the pixels can be appropriately adjusted, and each of the plurality of light-emitting elements 61 can be disposed between the pixels.

The infrared light irradiated from the plurality of light-emitting elements 61 can be reflected by the user's face and a light-receiving element 71 of the light-receiving module 70 can receive the reflected light to generate a three-dimensional feature map. As described herein, one or more light-emitting elements are configured to emit light and one or more light-receiving elements are configured to receive reflected light based on the light emitted by the one or more light-emitting elements. In other words, the one or more light-receiving elements are configured to receive light which has been emitted by the one or more light-emitting elements and has subsequently been reflected by one or more surfaces.

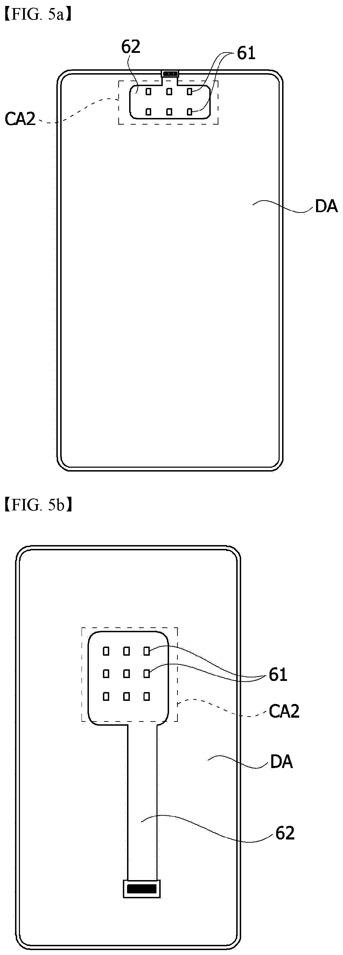

FIGS. 5a to 5c are views illustrating the second display area disposed at various positions.

Referring to FIGS. 5a to 5c, the plurality of light-emitting elements 61 can be disposed at various positions between the pixels and at different areas on the display screen, and with different amounts of spacing between the plurality of light-emitting elements 61. The plurality of light-emitting elements 61 can receive power through a flexible printed circuit board 62. An area of the flexible printed circuit board 62 can be variously modified according to the spaced positions and number of the plurality of light-emitting elements 61.

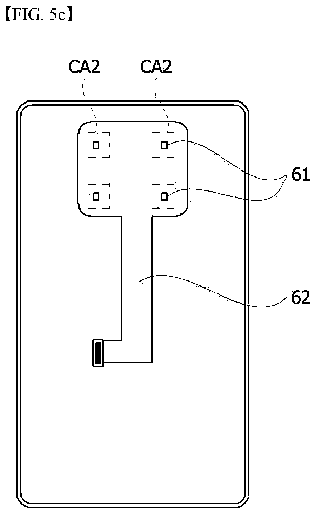

As an example, as shown in FIG. 5a, the plurality of light-emitting elements 61 can be disposed on an upper end of the display area. Alternatively, as shown in FIG. 5b, the plurality of light-emitting elements 61 can be disposed in a central area of the display area, or as shown in FIG. 5c, each of the light-emitting elements 61 can be spaced relatively far apart from each other and thus a plurality of second divided areas CA2 can be disposed to be spaced apart from each other.

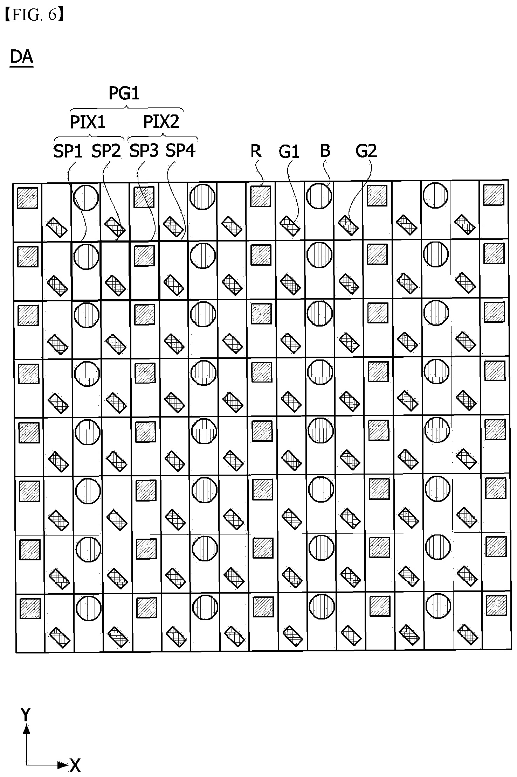

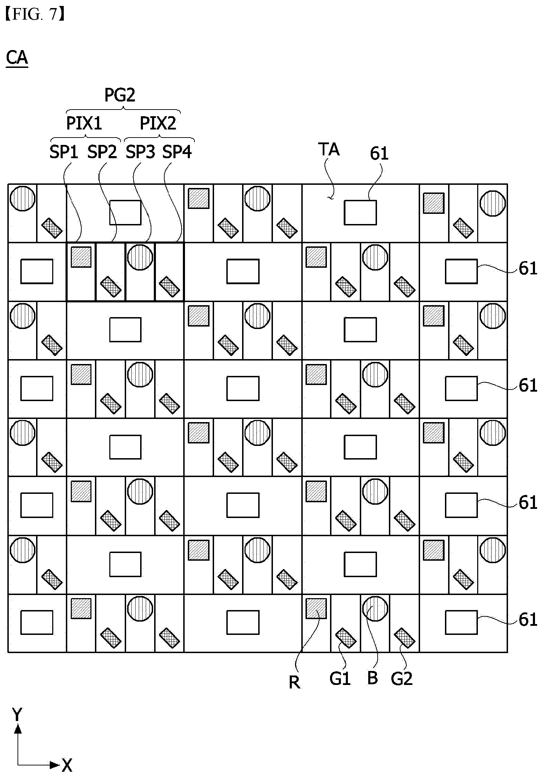

FIG. 6 is a view illustrating a pixel arrangement in a first display area according to one embodiment of the present disclosure. FIG. 7 is a view illustrating pixels and light-transmitting areas of a second display area according to an embodiment of the present disclosure.

Referring to FIG. 6, a first display area DA can include a plurality of first pixel groups PG1 arranged in a matrix form. In the plurality of first pixel groups PG1, two sub-pixels can form one pixel using a sub-pixel rendering algorithm. For example, a first unit pixel PIX1 can include R and G1 sub-pixels SP1 and SP2, and a second unit pixel PIX2 can include B and G2 sub-pixels SP3 and SP4. Insufficient color representation in each of the unit pixels PIX1 and PIX2 can be compensated with an average value of pieces of corresponding color data between neighboring pixels. However, the present disclosure is not necessarily limited thereto, and the plurality of first pixel groups PG1 can be real-type pixels including R, G, and B sub-pixels or R, G, B and W sub-pixels.

Referring to FIG. 7, a second display area CA can include a plurality of second pixel groups PG2 and a plurality of light-transmitting areas TA. The plurality of light-transmitting areas TA can be disposed between the plurality of second pixel groups PG2. Specifically, each of the light-transmitting areas TA and the second pixel groups PG2 can be alternately disposed in a first direction and a second direction (e.g., in an arrangement similar to a chess board). A plurality of light-emitting elements 61 or various sensors can be disposed below the light-transmitting areas TA. In this situation, a resolution of the second display area CA can be reduced relative to a resolution of the first display area DA by the extent to which an area of the light-transmitting area TA increases.

However, the plurality of light-emitting elements 61 may not necessarily be disposed in the light-transmitting areas TA, but can be properly disposed in an area from which some pixels are removed (e.g., every tenth subpixel can be replaced with a light-emitting element 61, or light-emitting elements 61 can be randomly distributed in places where a subpixel would normally reside).

The light-transmitting area TA can include transparent media having high light transmittance without having metal so that light can be incident with minimum light loss. The light-transmitting area TA can be made of transparent insulating materials without including metal lines or pixels. As the light-transmitting area TA becomes larger, the light transmittance of the second display area CA can be higher.

Each of the plurality of second pixel groups PG2 can include one or two pixels. For example, in each of the second pixel groups PG2, a first unit pixel PIX1 can include R and G1 sub-pixels SP1 and SP2, and a second unit pixel PIX2 can include B and G2 sub-pixels SP3 and SP4. The shape and arrangement of pixels of the second pixel group PG2 can be the same as or different from those of the first pixel group PG1.

The shape of the light-transmitting area TA is illustrated as being a quadrangular shape, but the present disclosure is not limited thereto. For example, the light-transmitting area TA can be designed in various shapes, such as a circular shape, an elliptical shape, a polygonal shape, diamond shape, triangular shape, or the like.

All metal electrode materials can be removed from the light-transmitting area TA. Accordingly, lines of the pixels can be disposed outside the light-transmitting area TA. Thus, light can be effectively incident through the light-transmitting area TA. However, the present disclosure is not necessarily limited thereto, and the metal electrode material can be present in a partial area of the light-transmitting area TA.

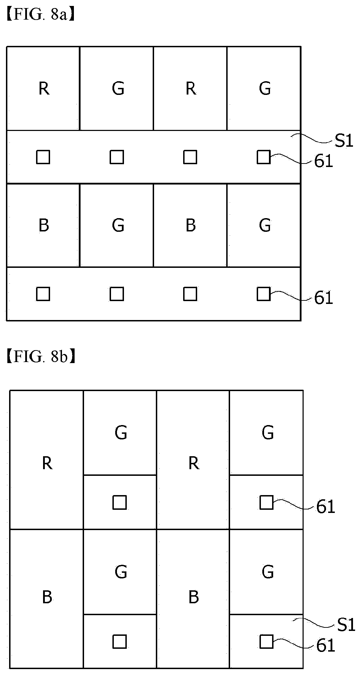

FIGS. 8a to 8d are views illustrating various pixel structures and arrangements in which the plurality of light-emitting elements are disposed.

Referring to FIG. 8a, in the second display area CA, the PPI of the pixels can be maintained as it is in the first display area DA, but the size of each sub-pixel can be reduced, so that a space in which the plurality of light-emitting elements 61 are disposed can be ensured. The size of each of a plurality of sub-pixels can all be reduced to form a separation space S1 between pixel lines, and the plurality of light-emitting elements 61 can be disposed in the separation space S1. Accordingly, the size of the sub-pixel of the second display area CA can be smaller than a size of the sub-pixel of the first display area DA, even though the same PPI can be maintained across both the first display area DA and the second display area CA.

Referring to FIG. 8b, a separation space S1 can be formed by relatively reducing only the size of a green (G) sub-pixel, and the plurality of light-emitting elements 61 can be disposed in the separation space S1. Accordingly, the size of the green (G) sub-pixel of the second display area CA can be smaller than a size of the sub-pixel of the green of the first display area DA, while sizes of the red (R) and blue (B) sub-pixels are maintained to be the same in both the first display area DA and the second display area CA. Alternatively, only the size of the red (R) subpixels or only a size of the blue (B) sub-pixels can be reduced in order to provide adequate separation space S1 for disposed the plurality of light-emitting elements 61.

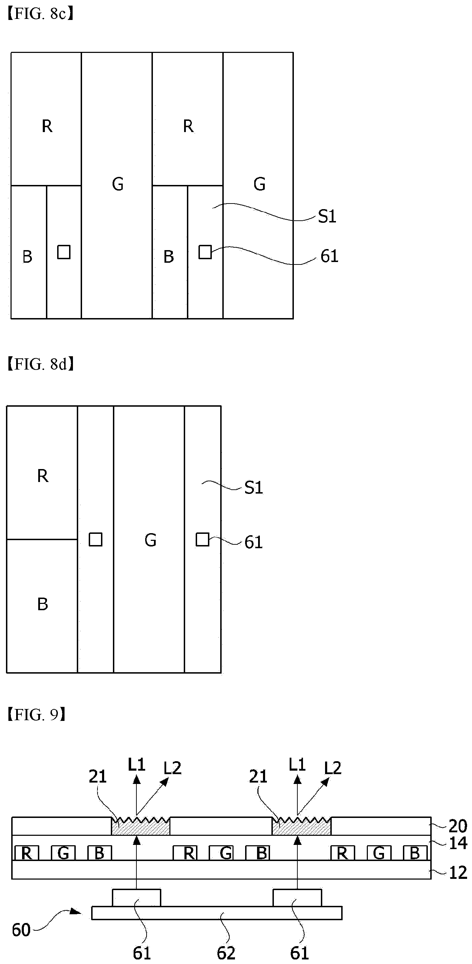

Referring to FIG. 8c, a separation space S1 can be formed by relatively reducing the size of a blue (B) sub-pixel, and the plurality of light-emitting elements 61 can be disposed in the separation space S1. Accordingly, the size of the blue (B) sub-pixel of the second display area CA can be smaller than a size of the sub-pixel of the blue of the first display area DA.

In addition, a separation space S1 can be formed between the sub-pixels as shown in FIG. 8d, and the plurality of light-emitting elements 61 can be disposed in the separation space S1. According to this configuration, the plurality of light-emitting elements 61 can be distributed while maintaining the resolution of the pixels as it is in the first display area DA. In this situation, in order to compensate for luminance, a data voltage applied to the sub-pixel can be increased (e.g., the smaller subpixels in the second display area CA can be driven brighter to compensate for their smaller size).

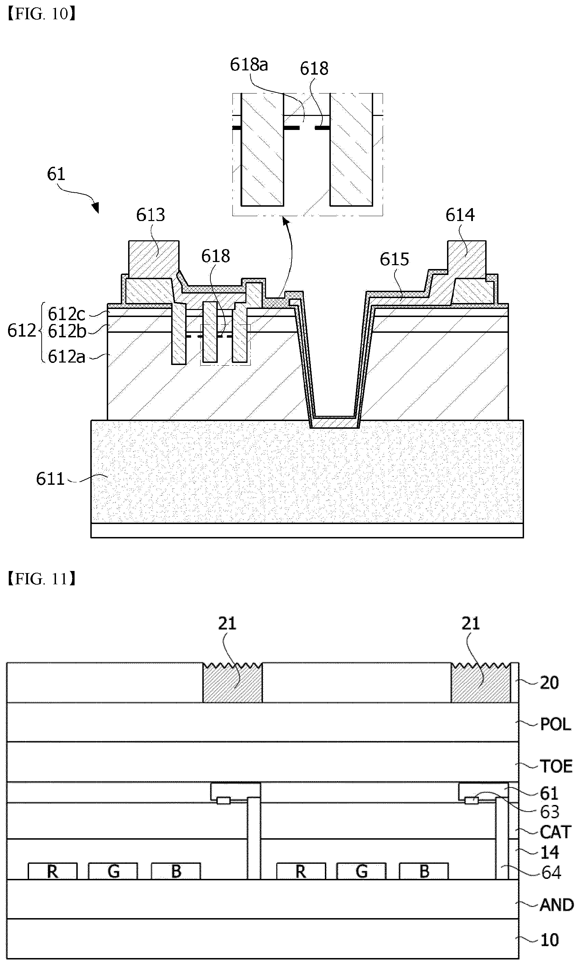

FIG. 9 is a view illustrating a state in which light emitted from the plurality of light-emitting elements is diffracted by a diffraction pattern. FIG. 10 is a cross-sectional view of the light-emitting element.

Referring to FIG. 9, the plurality of light-emitting elements 61 can be disposed below the display panel 100. The plurality of light-emitting elements 61 can be disposed so as not to overlap a plurality of pixels in a vertical direction. When the plurality of light-emitting elements 61 are disposed between pixels, it may not only mean that the plurality of light-emitting elements 61 are disposed between the pixels on the same plane, but also it can also include a structure in which the plurality of light-emitting elements 61 do not overlap the pixels in the vertical direction while being disposed on different planes.

A plurality of diffraction patterns 21 can be formed in the cover glass 20 at an area overlapping the plurality of light-emitting elements 61. The diffraction pattern can be formed by patterning the cover glass, but the present disclosure is not necessarily limited thereto, and various pattern forming methods can be selected without limitation. As an example, a film on which a rotation pattern is formed can be attached.

In the light emitted from the plurality of light-emitting elements 61, a dot image (first-order beam) is formed by pattern information recorded in the diffraction pattern 21, and non-diffracted beam components (zero-order beam) can be emitted as it is.

According to the embodiment, since the plurality of light-emitting elements 61 are spaced apart from each other and output light, when the number and output of the light-emitting elements 61 are adjusted, an emitted zero-order beam L1 can be used as a flood illuminator.

In the plurality of light-emitting elements 61, diffraction efficiency is determined by the degree of collimation and coherence, and a proportion of a first-order beam L2 can be adjusted by adjusting the diffraction efficiency. The diffraction efficiency can be adjusted using a collimator lens or the like. In addition, in order to increase the proportion of the first-order beam L2, the number of the light-emitting elements can be increased.

In order to ensure reliability of face recognition, the diffraction efficiency is preferably set such that the first-order beam L2 is larger than the zero-order beam L1. In addition, a ratio (zero-order beam:first-order beam) of the zero-order beam L1 and the first-order beam L2 can be adjusted to be in a range of 1:2 to 1:7 in order to stably generate a three-dimensional feature map using the first-order beam L2 while using the zero-order beam L1 as a flood illuminator.

When the ratio of the zero-order beam L1 and the first-order beam L2 is less than 1:2 (e.g., 1:1.5), the first-order beam can be relatively insufficient, and thus it can be difficult to stably form the three-dimensional feature map. In addition, when the ratio of the zero-order beam L1 and the first-order beam L2 is greater than 1:7 (e.g., 1:8), a light amount of the zero-order beam can be relatively small, and thus it can be difficult to perform the function of a flood illuminator.

Referring to FIG. 10, the plurality of light-emitting elements 61 can include a vertical cavity surface emitting laser (VCSEL) made in a small size. Each of the light-emitting elements 61 can be miniaturized to a size sufficient to be distributed between the pixels.

The VCSEL has an advantage of high coupling efficiency because it can oscillate in a single longitudinal mode of a narrow spectrum and also it has a small radiation angle.

Each of the light-emitting elements 61 can include a support substrate 611, a first reflective layer 612a disposed on the support substrate 611, a laser cavity 612b disposed on the first reflective layer 612a, a second reflective layer 612c disposed on the laser cavity 612b, and a first pad 614 and a second pad 613 disposed on the second reflective layer 612c.

The support substrate 611 can be a semi-insulating or conductive substrate. As an example, the substrate can be a GaAs substrate with a high doping concentration, and can be doped with a dopant. A buffer layer, such as an AlGaAs or GaAs thin film, can be further disposed on the substrate as needed, but the present disclosure is not necessarily limited thereto.

The first reflective layer 612a can include a distributed Bragg reflector (DBR) having an n-type superlattice structure. The first reflective layer 612a can be epitaxially deposited on the substrate by a technique, such as metal organic chemical vapor deposition (MOCVD), molecular beam epitaxy (MBE), or the like.

A pair of reflective layers can be alternately stacked in the first reflective layer 612a. A first sub-reflective layer and a second sub-reflective layer can all be AlGaAs, but the first sub-reflective layer can have a higher aluminum composition.

The laser cavity 612b can include one or more well layers and barrier layers. The well layer can be formed of one selected from among GaAs, AlGaAs, AlGaAsSb, InAlGaAs, AlInGaP, GaAsP, and InGaAsP, and the barrier layer can be formed of one selected from among AlGaAs, InAlGaAs, InAlGaAsP, AlGaAsSb, GaAsP, GaInP, AlInGaP, and InGaAsP.

The laser cavity 612b can be designed to have sufficient optical gain. As an example, the laser cavity according to the embodiment can include a center having the well layer that has a thickness and a composition ratio that are suitable to emit light in an infrared wavelength band. However, a wavelength band of a laser output by the well layer is not particularly limited, and can emit other colors of light (e.g., for providing a flashlight function or a fingerprint reader function).

An oxide layer 618 can be disposed on the laser cavity. The oxide layer 618 can include a semiconductor compound including aluminum such as AlAs, AlGaAs, and InAlGaAs. The oxide layer according to the embodiment can include an unoxidized opening 618a at a center thereof (e.g., a hole for emitting laser light).

The oxide layer 618 can have a relatively high resistance but can have a relatively low refractive index. Accordingly, a current can be injected into the opening 618a so that laser light can be collected at a center of an element.

The second reflective layer 612c can be disposed above the oxide layer. The second reflective layer 612c can include a plurality of third sub-reflective layers and a plurality of fourth sub-reflective layers.

The third sub-reflective layer can have a composition of AlGaAs, and the fourth sub-reflective layer can have a composition of GaAs. A reflectance of the first reflective layer can be lower than a reflectance of the second reflective layer. Thus, light generated in the laser cavity 612b can pass through the opening 618a of the oxide layer 618 and can be emitted through the support substrate 611.

The first pad 614 and the second pad 613 can be disposed on the second reflective layer 612c. The first pad 614 can be electrically connected to the support substrate 611 and the first reflective layer 612a through an electrode 615 extending to a through hole formed in the epitaxial structure. That is, the VCSEL can be a flip chip type. However, the present disclosure is not necessarily limited thereto, and the VCSEL can have various types of electrode arrangements, such as a horizontal electrode arrangement or a vertical electrode arrangement. In addition, a laser structure can be variously modified to make the VCSEL smaller.

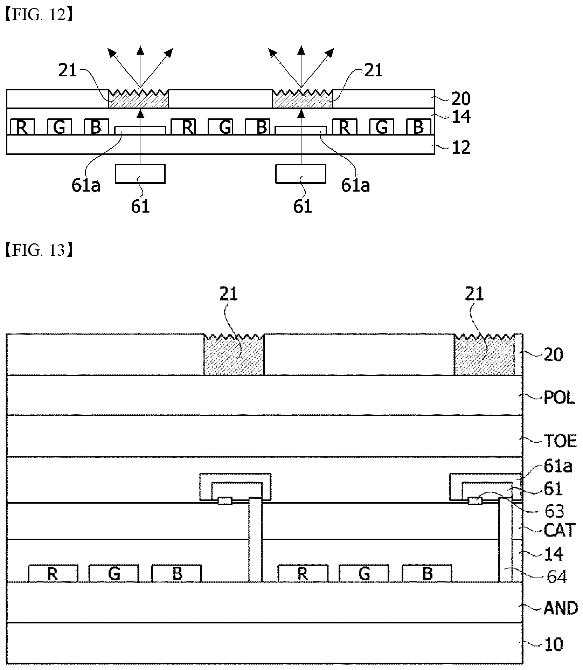

FIG. 11 is a view illustrating a structure in which the plurality of light-emitting elements are disposed inside the display panel. FIG. 12 is a view illustrating a structure in which a lens is disposed above each of the plurality of light-emitting elements. FIG. 13 is a view illustrating a structure in which the lens is disposed on an upper portion of the light-emitting element.

Referring to FIG. 11, the element layer 14, in which a plurality of pixels are disposed, is disposed between an anode AND and a cathode CAT, but the plurality of light-emitting elements 61 can be disposed on an upper portion of the cathode CAT and connected to a pad electrode 63. In addition, the plurality of light-emitting elements 61 can be electrically connected to the anode AND through a through electrode 64. Also, the through electrode 64 can be insulated from the cathode CAT. For example, an insulating layer can be formed between the through electrode 64 and the cathode electrode CAT. This structure can be applied when the light-emitting element 61 is a flip chip. When the light-emitting element 61 has a vertical structure in which a first electrode is disposed on the light-emitting element and a second electrode is disposed below the light-emitting element, the light-emitting element 61 can be disposed between the anode AND and the cathode CAT.

Light emitted through the plurality of light-emitting elements 61 can pass through a touch panel TOE and a polarizing plate POL, and can be separated into a zero-order beam and a first-order beam due to the diffraction pattern 21 of the cover glass 20.

According to this configuration, a separate flexible printed circuit board can be omitted, and when the display panel 100 is formed, the light-emitting module 60 can be manufactured together. Also, lines that supply power to the plurality of light-emitting elements 61 can be additionally formed.

Referring to FIG. 12, a first lens 61a can be disposed between the diffraction pattern 21 and the light-emitting element 61. The first lens 61a can be a collimator lens that converts the light emitted from the light-emitting element 61 into parallel light, but the present disclosure is not necessarily limited thereto, and a lens for desired light control can be applied thereto. As described above, the first lens 61a is disposed between the diffraction pattern and the light-emitting element 61 so that the diffraction efficiency of the zero-order beam and the first-order beam can be adjusted.

According to the embodiment, the plurality of first lenses 61a can be disposed in the element layer 14, but are not necessarily limited thereto, and can be formed in a layer without limitation as long as the layer is between the diffraction pattern and the light-emitting element 61. The first lens 61a can be formed in the element layer 14 by applying resin.

Referring to FIG. 13, the first lens 61a can be directly formed on the light-emitting element 61. According to this configuration, light emitted from the light-emitting element 61 can be directly incident on the first lens 61a to increase light coupling efficiency.

The first lens 61a can be formed only on an upper surface of the light-emitting element 61, but is not necessarily limited thereto, and can be formed up to a side surface of the light-emitting element 61 to protect the light-emitting element 61.

The first lens 61a can be formed on the light-emitting element 61 in advance, and then the display panel 100 can be disposed, but the present disclosure is not necessarily limited thereto. As an example, the first lens 61a can be formed by arranging the light-emitting element 61 on the cathode CAT and then applying resin. In this situation, a portion of the resin can be filled between the light-emitting element 61 and the cathode CAT to serve to fix the light-emitting element 61.

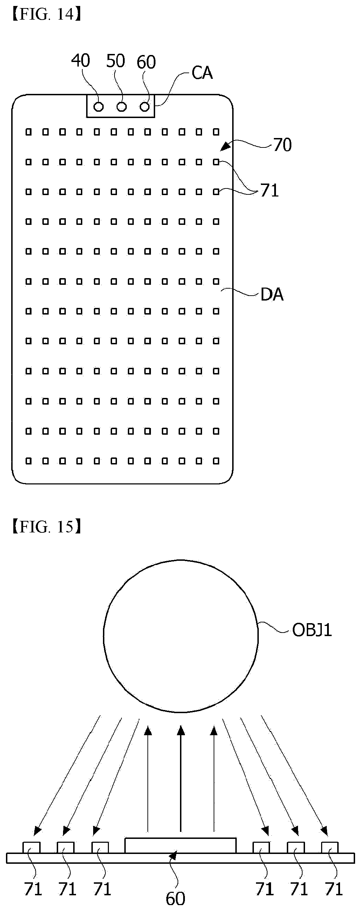

FIG. 14 is a conceptual diagram of a display device according to a second embodiment of the present disclosure. FIG. 15 is a view illustrating a structure in which a plurality of light-receiving elements receive reflected light.

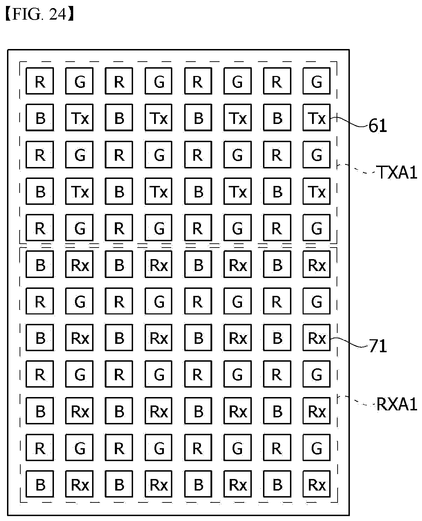

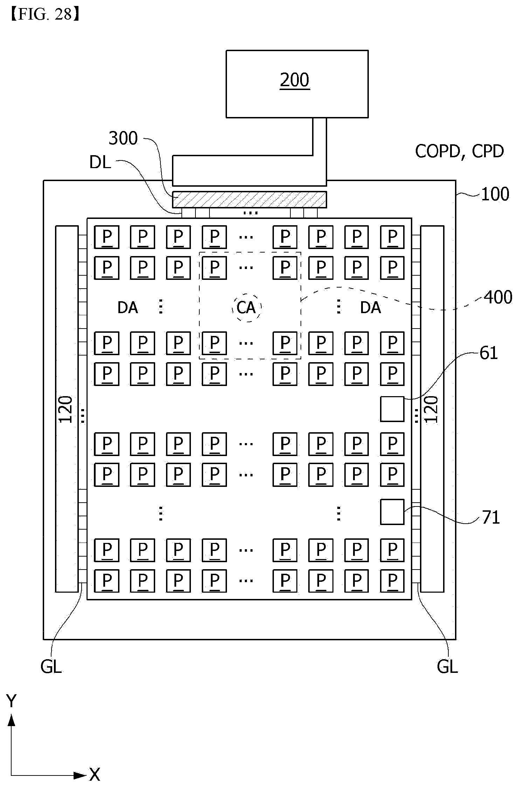

Referring to FIGS. 14 and 15, the display device can include a display panel 100 including a plurality of pixels and a light-receiving module 70, and the light-receiving module 70 can include a plurality of light-receiving elements 71 distributed and disposed between the plurality of pixels. For example, the arrangement in FIG. 14 is similar to the arrangement in FIG. 1, except rather than distributing a plurality of light-emitting element 61 within the display panel between the subpixels, it is a plurality of light-receiving elements 71 that are distributed within the display panel between the subpixels. Of course, according to an embodiment of the present disclosure, both of the plurality of light-receiving elements 71 and the plurality of light-emitting element 61 can be distributed within the display panel between the subpixels (e.g., see FIGs. 24 and 28, to be discussed later).

The plurality of light-receiving elements 71 can be distributed throughout the display area. Each of the light-receiving elements 71 can be a component corresponding to a unit pixel of an image sensor. As an example, one light-receiving element can be a component corresponding to one unit pixel and can also be a component corresponding to a plurality of unit pixels. Accordingly, each of the light-receiving elements 71 can perform a function of an image capturing unit that captures an image of a corresponding area. However, the present disclosure is not necessarily limited thereto, and the plurality of light-receiving elements 71 can be disposed only in a central area of a display area, and can be disposed only on a portion of an upper end of the display area.

A plurality of sensors 40, 50, and 60, excluding the light-receiving module 70, can be disposed in a second display area CA. The second display area CA can be an area in which the plurality of sensors 40, 50, and 60 are disposed, and a first display area DA can be an area in which the remaining areas except for the second display area CA or the plurality of light-receiving elements 71 are disposed. The first display area DA and the second display area CA can all output an image and have the same resolution, but the resolution of the second display area CA can be lower than that of the first display area DA.

The plurality of sensors 40, 50, and 60 can include at least one of an image sensor, a proximity sensor, an illumination sensor, a gesture sensor, a motion sensor, a fingerprint recognition sensor, and a biometric sensor. As an example, a first sensor can be an infrared sensor and a second sensor can be an image sensor configured to capture an image or a video, but the present disclosure is not necessarily limited thereto. The plurality of sensors 40, 50, and 60 can be components of various sensors.

In the light-receiving module 70 according to the embodiment, since the plurality of light-receiving elements 71 are distributed and disposed between the pixels, a separate independent space in which the light-receiving module is received can be omitted. According to the embodiment, there is an advantage in that the display area can be expanded by dividing the light-receiving module 70 into the plurality of light-receiving elements 71 and distributing and disposing the plurality of light-receiving elements 71 on the panel (e.g., the size of a notch portion in screen for housing sensors can be reduced or eliminated entirely). Light emitted from the light-emitting module 60 can be reflected by a user OBJ1, and the plurality of light-receiving elements 71 distributed in the panel can receive the reflected light.

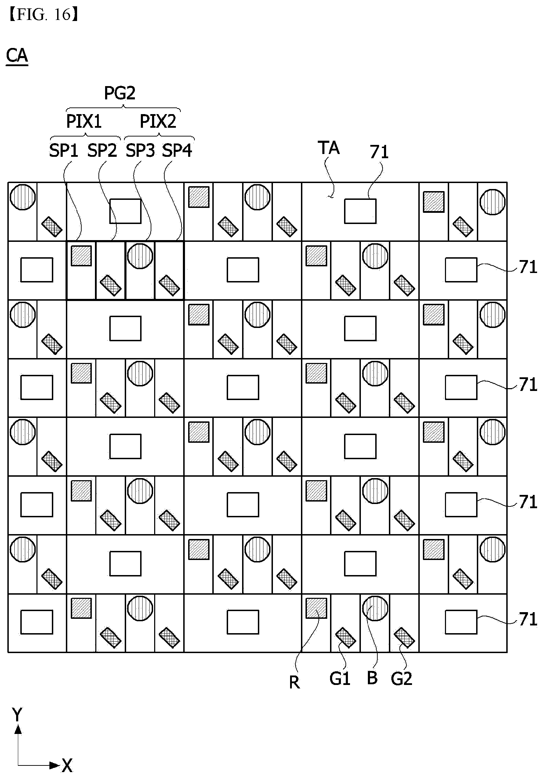

FIG. 16 is a view illustrating a state in which the plurality of light-receiving elements are disposed between the pixels.

Referring to FIG. 16, the second display area CA can include a plurality of second pixel groups PG2 and a plurality of light-transmitting areas TA. The plurality of light-transmitting areas TA can be disposed between the plurality of second pixel groups PG2. Specifically, each of the light-transmitting areas TA and the second pixel groups PG2 can be alternately disposed in a first direction and a second direction (e.g., in an arrangement similar to a chess board). The plurality of light-receiving elements 71 can be disposed in the light-transmitting areas TA. In this situation, a resolution of the first display area DA can be reduced by the extent to which an area of the light-transmitting area TA increases.

The light-transmitting area TA can include transparent media having high light transmittance without having metal so that light can be incident with minimum light loss. The light-transmitting area TA can be made of transparent insulating materials without including metal lines or pixels.

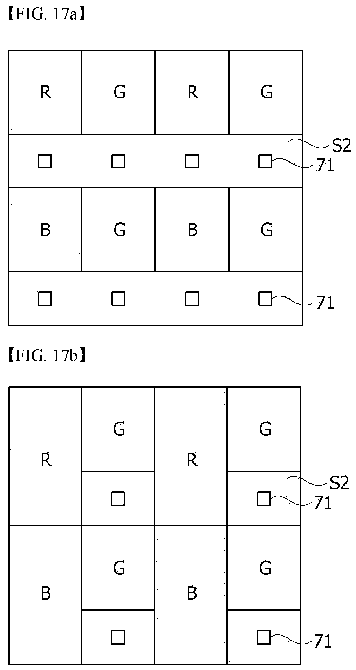

FIGS. 17a to 17d are views illustrating various pixel structures in which the plurality of light-receiving elements are disposed.

Referring to FIG. 17a, the PPI of the pixels can be maintained as it is and the size of the pixel can be reduced, so that a space in which the plurality of light-receiving elements 71 are disposed can be ensured. The size of each of the plurality of pixels can all be reduced to form a separation space S2 between pixel lines, and the plurality of light-receiving elements 71 can be disposed in the separation space S2. Accordingly, the size of the sub-pixel of the second display area CA can be smaller than a size of the sub-pixel of the first display area DA, even though the same PPI can be maintained across both the first display area DA and the second display area CA.

Referring to FIG. 17b, a separation space S2 can be formed by relatively reducing only the size of a green (G) sub-pixel, and the plurality of light-receiving elements 71 can be disposed in the separation space S2. Accordingly, the size of the green (G) sub-pixel of the second display area CA can be smaller than a size of the sub-pixel of the green of the first display area DA, while sizes of the red (R) and blue (B) sub-pixels are maintained to be the same in both the first display area DA and the second display area CA. Alternatively, only the size of the red (R) subpixels or only a size of the blue (B) sub-pixels can be reduced in order to provide adequate separation space S1 for disposed the plurality of light-receiving elements 71.

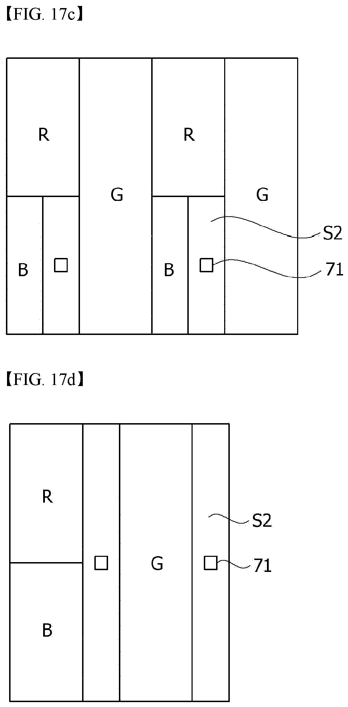

Referring to FIG. 17c, a separation space S2 can be formed by relatively reducing the size of a blue (B) sub-pixel, and the plurality of light-receiving elements 71 can be disposed in the separation space S2. Accordingly, the size of the blue (B) sub-pixel of the second display area CA can be smaller than a size of the sub-pixel of the blue of the first display area DA.

In addition, a separation space S2 can be formed between the pixels as shown in FIG. 17d, and the plurality of light-receiving elements 71 can be disposed in the separation space S2. According to this configuration, the plurality of light-receiving elements 71 can be distributed while maintaining the resolution of the pixels as it is in the first display area DA. In this situation, in order to compensate for luminance, a data voltage applied to the pixel can be increased (e.g., the smaller subpixels in the second display area CA can be driven brighter to compensate for their smaller size).

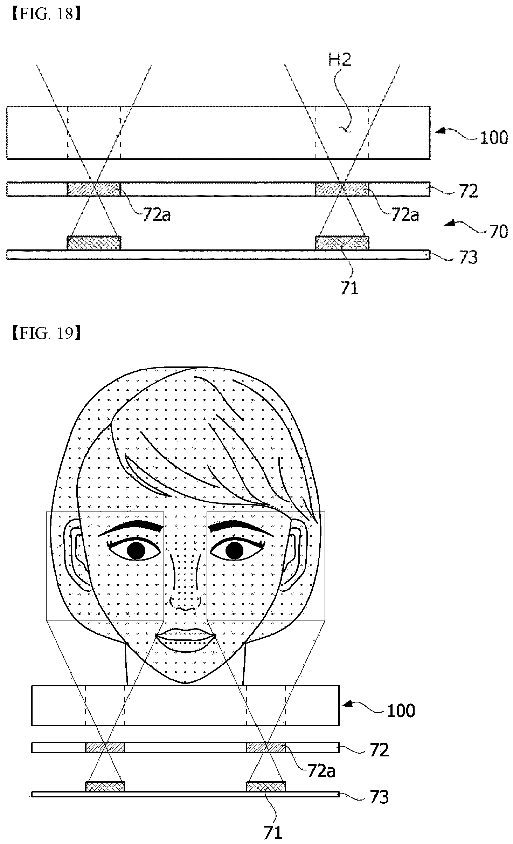

FIG. 18 is a view illustrating a state in which the light-receiving module is disposed below the display panel. FIG. 19 is a view illustrating a process of acquiring a face image through the plurality of light-receiving elements.

Referring to FIG. 18, the light-receiving module 70 is disposed below the display panel and can receive data about light incident on the display panel that passes through the light-transmitting area TA formed in the display panel 100. A second lens 72a can be disposed between the light-receiving module 70 and the display panel 100 and can control a path of incident light. The plurality of light-receiving elements 71 can be disposed on a circuit board 73, and the second lens 72a can be formed on a lens substrate 72. The second lens 72a and the lens substrate 72 can be integrally formed, but the present disclosure is not necessarily limited thereto, and the second lens 72a can be separately manufactured and then attached to the lens substrate 72.

An opening area H2 can be formed in the display panel 100 so that light is incident on the light-receiving element 71. The opening area H2 can be a pin hole formed between the plurality of pixels and can also be the light-transmitting area described above.

Referring to FIG. 19, the plurality of light-receiving elements 71 can acquire an image of an area allocated in a corresponding position (e.g., corresponding to different parts of a user's face). A host system of the display device can synthesize images acquired by the plurality of light-receiving elements 71 to generate a three-dimensional feature map (e.g., the partial images obtained from the different light-receiving elements 71 can be stitched together by various techniques).

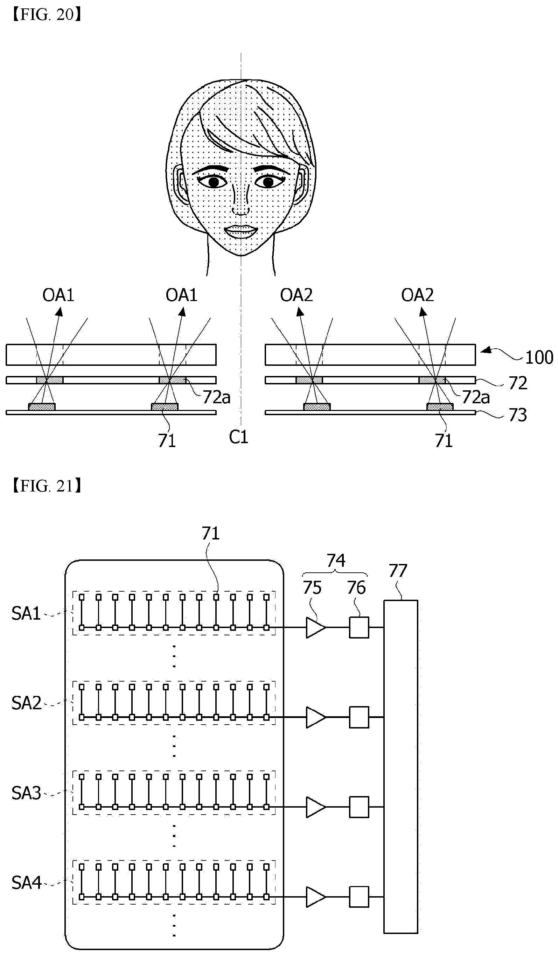

FIG. 20 is a view illustrating a state in which an optical axis is inclined according to a position of the light-receiving element.

Referring to FIG. 20, each of the plurality of light-receiving elements 71 can have a focus adjusted according to a position thereof. When pixels of an image sensor are separated and disposed, an image of a wider area is acquired than before, and thus it is desirable to adjust a focus angle to a unique focus angle for each position (e.g., the lenses can have different offset positions, in order to differently adjust the focus angles for different light-receiving elements 71 based on their respective locations within the display panel).

In the embodiment, an image capturing angle can be adjusted according to a face direction of a user through a method of shifting the second lens 72a of the light-receiving element 71. As an example, for the plurality of light-receiving elements 71 disposed on a left side with respect to a center of the panel, the second lens 72a can be disposed by being shifted to the right as compared to the light-receiving element 71 so that an optical axis OA1 is directed toward a center C1.

Further, for the plurality of light-receiving elements 71 disposed on a right side with respect to the center of the panel, the second lens 72a can be disposed by being shifted to the left as compared to the light-receiving element 71 so that an optical axis OA2 is directed toward the center C1.

In addition, for each of the light-receiving elements 71 disposed at a lower end of the display panel 100 and the light-receiving elements 71 disposed at an upper end of the display panel 100, a focus can be adjusted by shifting the second lens 72a so that the optical axis is directed toward the center of the panel.

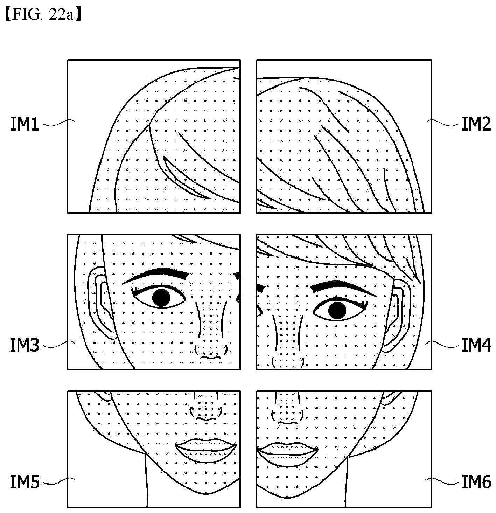

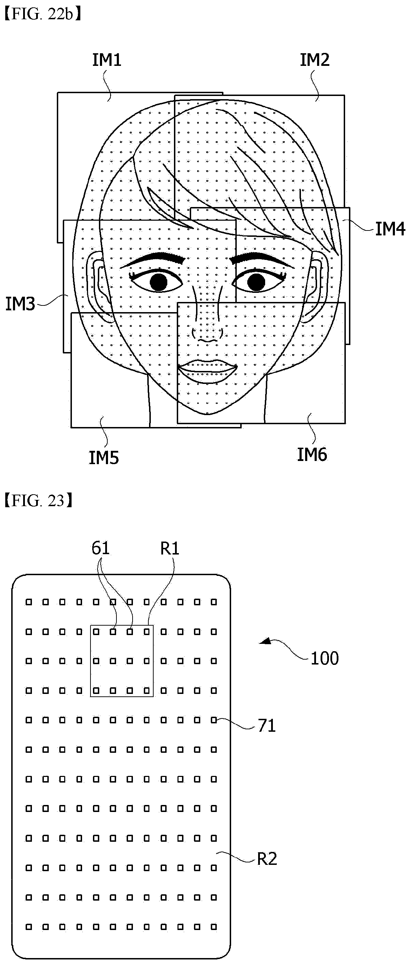

FIG. 21 is a view illustrating a state in which a sensing circuit is divided for each of a plurality of sensing areas. FIGS. 22a and 22b are views illustrating a process of synthesizing a plurality of divided images.

Referring to FIG. 21, the light-receiving module 70 can include a plurality of sensing areas SA1, SA2, SA3, and SA4, and the plurality of light-receiving elements 71 disposed in each of the sensing areas SA1, SA2, SA3, and SA4 can each be connected to a sensing circuit 74. The sensing circuit 74 can include various circuit elements for signal reception, such as an operational amplifier 75 and an analog-to-digital converter 76.

When the plurality of light-receiving elements 71 are distributed and disposed to acquire images, a signal delay and a noise deviation can occur according to a distance of each of the plurality of light-receiving elements 71.

Accordingly, according to the embodiment, the sensing area is divided into the plurality of sensing areas SA1, SA2, SA3, and SA4, and the sensing circuit 74 is disposed in each of the sensing areas SA1, SA2, SA3, and SA4 to receive signals in parallel, so that the signal delay and noise generation can be minimized. Signals transmitted through a plurality of sensing circuits 74 can be transmitted to an image synthesizing unit 77 to generate a synthesized image.

Referring to FIG. 22a, when the plurality of light-receiving elements 71 are distributed and disposed to acquire a plurality of images, an angle of view of each of the light-receiving elements 71 can overlap, and thus overlapping portions can be generated in acquired images IM1, IM2, IM3, IM4, IM5, and IM6. Accordingly, as shown in FIG. 22b, an area in which images overlap is extracted through an algorithm and an overlapping portion is removed to generate a synthesized image (e.g., the multiple images can be stitched together). A method of extracting an overlapped area is not particularly limited, and various image processing techniques can be used without limitation.

Further, in another embodiment, when a reference image is initially set without removing an overlapping portion when a face image of a user is acquired, it is possible to confirm the user by comparing the overlapped image itself with the reference image to determine whether it is matched with the user. That is, when the initially acquired reference image used to confirm the user is set as an image having the overlapped area as shown in FIG. 22a, the image detected for user confirmation can also be compared with the reference image without removing the overlapping portion. In this situation, a processing speed can be improved since a calculation process for calculating whether or not overlapping occurs can be omitted.

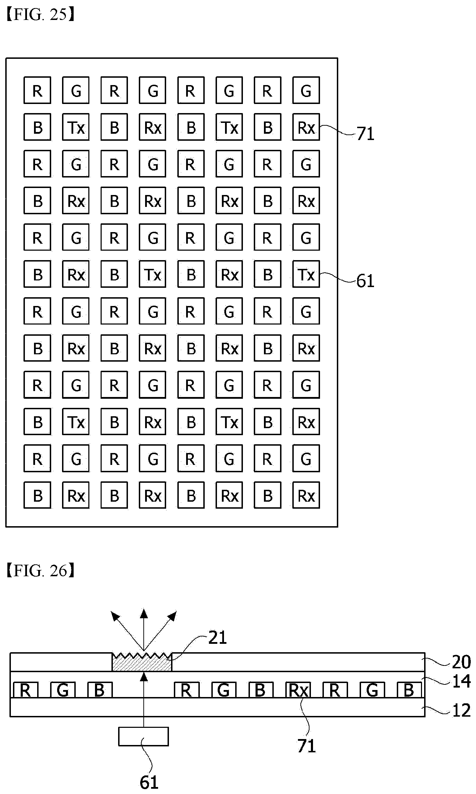

FIG. 23 is a conceptual diagram of a display device according to a third embodiment of the present disclosure. FIG. 24 is a first modified example of FIG. 23. FIG. 25 is a second modified example of FIG. 23.

Referring to FIG. 23, in a display area of a display panel 100, a plurality of light-emitting elements 61 of a light-emitting module 60 and a plurality of light-receiving elements 71 of a light-receiving module 70 can be distributed and disposed between pixels.

Since the plurality of light-emitting elements 61 and the light-receiving elements 71 are distributed and disposed between the pixels, a full-screen display can be implemented, and there is an advantage in which a separate space in which the light-emitting module 60 and the light-receiving module 70 are disposed can be reduced or eliminated to widen the display area (e.g., a notched area in the display panel for separated housing sensors can be omitted).

According to the embodiment, the plurality of light-emitting elements 61 can be disposed in a partial area R1 of the display panel 100 (e.g., distributed in an upper center portion of the display panel), and the plurality of light-receiving elements 71 can be disposed in a remaining area R2 of the display panel 100. According to this structure, the plurality of light-receiving elements 71 can have a shape that surrounds a light-emitting area. However, the present disclosure is not necessarily limited thereto, and the arrangement of the plurality of light-emitting elements 61 and the plurality of light-receiving elements 71 can be variously modified.

Referring to FIG. 24, the display panel 100 can include a light-emitting area TXA1 in which the plurality of light-emitting elements 61 are disposed, and a light-receiving area RXA1 in which the plurality of light-receiving elements 71 are disposed (e.g., the light-emitting elements 61 can be disposed together in one portion of the display panel, such as the upper half, and the light-receiving elements 71 can be disposed together in a different portion of the display panel, such as the lower half).

The light-emitting area TXA1 can include the plurality of pixels and the plurality of light-emitting elements 61. The plurality of light-emitting elements 61 can be disposed between the plurality of pixels. The light-emitting elements 61 can be disposed between the pixels in a state in which the existing PPI of the plurality of pixels is maintained. Alternatively, some pixels can be omitted and a light-transmitting area can be provided, and the plurality of light-emitting elements 61 can be disposed in the light-transmitting area. As a configuration in which the light-emitting element 61 is disposed, the above-described configurations can all be applied.

The light-receiving area RXA1 can include the plurality of pixels and the plurality of light-receiving elements 71. The plurality of light-receiving elements 71 can be disposed between the plurality of pixels. The light-receiving elements 71 can be disposed between the pixels in a state the existing PPI of the plurality of pixels is maintained. Alternatively, some pixels can be omitted and a light-transmitting area can be provided, and the plurality of light-receiving elements 71 can be disposed in the light-transmitting area.

Referring to FIG. 25, each of the plurality of light-emitting elements 61 and each of the plurality of light-receiving elements 71 can alternatively be disposed between the pixels (e.g., the light-emitting elements 61 and the light-receiving elements 71 can be evenly mixed across the display panel). According to this configuration, light emitted from the plurality of light-emitting elements can be emitted from the entire surface of the display device, and an area in which the light-receiving element can receive light can be increased. The configuration in which each of the plurality of light-emitting elements 61 and each of the plurality of light-receiving elements 71 are alternately disposed between the pixels is not necessarily limited thereto and variously modified (e.g., the light-emitting elements 61 and the light-receiving elements 71 can be randomly mixed across the display panel and in different concentrations or densities).

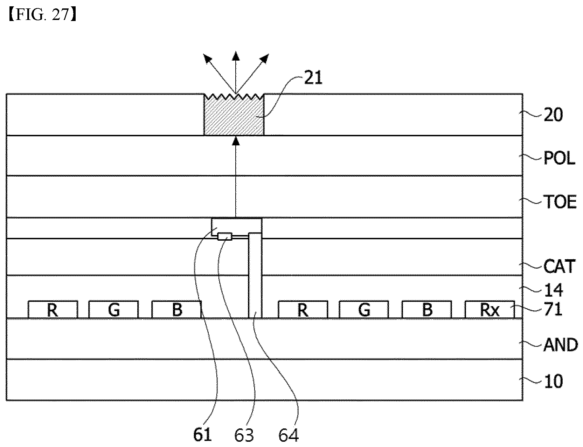

FIG. 26 is a view illustrating a structure in which the plurality of light-receiving elements are disposed on the panel. FIG. 27 is a view illustrating a structure in which the plurality of light-emitting elements are disposed on the panel.

Referring to FIG. 26, the plurality of light-emitting elements 61 can be disposed below the display panel 100. The plurality of light-emitting elements 61 can be disposed so as not to overlap with any of the plurality of pixels in a vertical direction. A diffraction pattern 21 can be formed on a cover glass 20 at an area overlapping each of the plurality of light-emitting elements 61.

In light emitted from the plurality of light-emitting elements 61, a dot image (first-order beam) is formed by pattern information recorded in the diffraction pattern 21, and non-diffracted beam components (zero-order beam) can be emitted as it is.

According to the embodiment, since the plurality of light-emitting elements 61 are spaced apart from each other and output light, when the number and output of the light-emitting elements 61 are adjusted, an emitted zero-order beam can be used as a flood illuminator.

The plurality of light-receiving elements 71 can be disposed between the pixels. Accordingly, a layer in which the plurality of light-emitting elements 61 are disposed and a layer in which the plurality of light-receiving elements 71 are disposed can be different. According to this configuration, the plurality of light-emitting elements 61 can be disposed at positions lower than those of the plurality of light-receiving elements 71. The plurality of light-emitting elements 61 can be connected through a separate circuit board to prevent a wiring structure from being complicated.

However, the present disclosure is not necessarily limited thereto, and the plurality of light-receiving elements 71 can also be disposed below the display panel 100. In this situation, a first circuit board electrically connecting the plurality of light-emitting elements 61 and a second circuit board electrically connecting the plurality of light-receiving elements 71 can be disposed. Alternatively, the plurality of light-emitting elements 61 and the plurality of light-receiving elements 71 can be disposed on one circuit board.

Referring to FIG. 27, the plurality of pixels are disposed between an anode AND and a cathode CAT of a circuit unit, but the plurality of light-emitting elements 61 can be disposed on an upper portion of the cathode CAT and electrically connected to the anode AND through a through electrode 64. Accordingly, the positions of the plurality of light-emitting elements 61 can be higher than those of the plurality of light-receiving elements 71 (e.g., Rx). This structure can be applied when the light-emitting element has a flip-chip structure.

Light emitted through the plurality of light-emitting elements 61 can pass through a touch panel TOE and a polarizing plate POL, and can be separated into a zero-order beam and a first-order beam due to the diffraction pattern 21 of the cover glass 20.

A first lens can be disposed between the diffraction pattern 21 and the light-emitting element 61. The first lens can condense light emitted from the light-emitting element 61 or convert the light into parallel light. Further, a second lens or pin hole can be disposed above the light-receiving element 71.

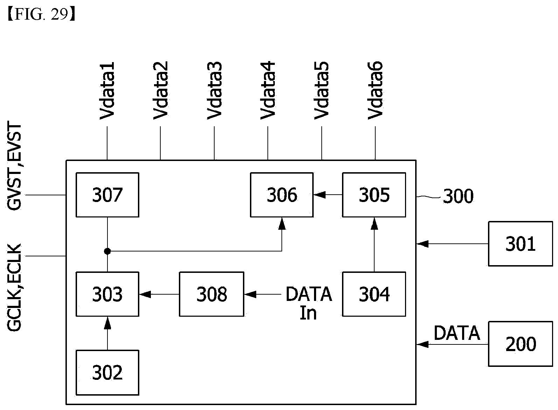

FIG. 28 is a block diagram illustrating a display panel and a display panel driving unit according to an embodiment of the present disclosure. FIG. 29 is a block diagram schematically illustrating a configuration of a driver integrated circuit (IC).

Referring to FIGS. 28 and 29, the display device can include a display panel 100 having a pixel array disposed on a screen, a display panel driving unit, and the like.

The pixel array of the display panel 100 can include data lines DL, gate lines GL intersecting the data lines DL, and pixels P arranged in a matrix form defined by the data lines DL and the gate lines GL.

In the display panel 100, the screen on which an input image is reproduced can include a first display area DA and a second display area CA. The second display area CA can be an area in which a plurality of sensors are disposed as described above. In addition, a plurality of light-emitting elements 61 or light-receiving elements 71 can be disposed in the first display area DA or the second display area CA according to the type of the sensor.

Sub-pixels of each of the first display area DA and the second display area CA can include a pixel circuit. The pixel circuit can include a driving element configured to supply current to a light-emitting element OLED, a plurality of switch elements configured to sample a threshold voltage of the driving element and switch current paths of the pixel circuit, a capacitor configured to maintain a gate voltage of the driving element, and the like. The pixel circuit can be disposed below the light-emitting element.

The second display area CA can include a light-transmitting area TA disposed between pixel groups, and a plurality of sensors disposed below the second display area CA. In an image capturing mode, the camera module 400 can perform photoelectric conversion on light incident through the second display area CA using an image sensor and convert pixel data of an image, which is output from the image sensor, into digital data to output captured image data.

The display panel driving unit can write the pixel data of the input image to the pixels P. The pixels P can be interpreted as a pixel group including a plurality of sub-pixels.

The display panel driving unit can include a data driving unit 306 configured to supply a data voltage of the pixel data to the data lines DL, and a gate driving unit 120 configured to sequentially supply a gate pulse to the gate lines GL. The data driving unit 306 can be integrated into a driver IC 300. The display panel driving unit can further include a touch sensor driving unit omitted from the drawing.

The driver IC 300 can be attached to the display panel 100. The driver IC 300 receives pixel data of an input image and a timing signal from a host system 200, supplies a data voltage of the pixel data to the pixels, and synchronizes the data driving unit 306 with the gate driving unit 120.

The driver IC 300 can be connected to the data lines DL through data output channels to supply the data voltage of the pixel data to the data lines DL. The driver IC 300 can output a gate timing signal for controlling the gate driving unit 120 through gate timing signal output channels.

The gate timing signal generated from a timing controller 303 can include a gate start pulse VST, a gate shift clock CLK, and the like. The gate start pulse VST and the gate shift clock CLK can swing between a gate-on voltage VGL and a gate-off voltage VGH.

The gate timing signal (VST and CLK) output from a level shifter 307 can be applied to the gate driving unit 120 to control a shift operation of the gate driving unit 120.

The gate driving unit 120 can include a shift register formed on the circuit layer of the display panel 100 together with the pixel array. The shift register of the gate driving unit 120 can sequentially supply a gate signal to the gate lines GL under the control of the timing controller. The gate signal can include a scan pulse and an EM pulse of an emission signal.

The shift register can include a scan driving unit configured to output the scan pulse, and an EM driving unit configured to output the EM pulse. In FIG. 29, "GVST" and "GCLK" are gate timing signals that are input to the scan driving unit. "EVST" and "ECLK" are gate timing signals that are input to the EM driving unit.

The driver IC 300 can be connected to the host system 200, a first memory 301, and the display panel 100. The driver IC 300 can include a data reception and computation unit 308, the timing controller 303, the data driving unit 306, a gamma compensation voltage generation unit 305, a power supply unit 304, a second memory 302, and the like.

The data reception and computation unit 308 can include a reception unit configured to receive pixel data input as a digital signal from the host system 200 and a data computation unit configured to process the pixel data input through the reception unit to improve image quality.

The data computation unit can include a data restoration unit configured to perform restoration by decoding compressed pixel data, an optical compensation unit configured to add a preset optical compensation value to the pixel data, and the like. The optical compensation value can be set as a value for compensating for the luminance of each piece of pixel data based on the luminance of the screen that is measured based on a camera image captured in a manufacturing process.

The timing controller 303 can provide the pixel data of the input image received from the host system 200 to the data driving unit 306. The timing controller 303 can generate a gate timing signal for controlling the gate driving unit 120 and a source timing signal for controlling the data driving unit 306 to control operation timing of the gate driving unit 120 and the data driving unit 306.

The data driving unit 306 can convert digital data including the pixel data received from the timing controller 303 into a gamma compensation voltage using a digital-to-analog converter (DAC) and output a data voltage. The data voltage output from the data driving unit 306 can be supplied to the data lines DL of the pixel array through an output buffer connected to a data channel of the driver IC 300.

The gamma compensation voltage generation unit 305 can generate a gamma compensation voltage for each grayscale by dividing a gamma reference voltage received from the power supply unit 304 through a voltage divider circuit. The gamma compensation voltage is an analog voltage in which a voltage is set for each grayscale of the pixel data. The gamma compensation voltage output from the gamma compensation voltage generation unit 305 can be provided to the data driving unit 306.

The power supply unit 304 can generate power necessary to drive the driver IC 300, the gate driving unit 120, and the pixel array of the display panel 100 using a DC-DC converter. The DC-DC converter can include a charge pump, a regulator, a buck converter, a boost converter, and the like.

The power supply unit 304 can generate DC voltages such as a gamma reference voltage, a gate-on voltage VGL, a gate-off voltage VGH, a pixel driving voltage VDD, a low-potential power supply voltage VSS, an initialization voltage Vini, and the like by adjusting a DC input voltage received from the host system 200.

The gamma reference voltage can be supplied to the gamma compensation voltage generation unit 305. The gate-on voltage VGL and the gate-off voltage VGH can be supplied to the level shifter 307 and the gate driving unit 120. Pixel power voltages such as the pixel driving voltage VDD, the low-potential power supply voltage VSS, and the initialization voltages Vini can be supplied in common to the pixels P.

The initialization voltage Vini can be set to a DC voltage that is lower than the pixel driving voltage VDD and is lower than a threshold voltage of the light-emitting element OLED to initialize main nodes of the pixel circuits and suppress light emission of the light-emitting element OLED.

When power is supplied to the driver IC 300, the second memory 302 can store a compensation value, register setting data, and the like that are received from the first memory 301.

The compensation value can be applied to various algorithms for improving image quality. The compensation value can include the optical compensation value. The register setting data can define operations of the data driving unit 306, the timing controller 303, the gamma compensation voltage generation unit 305, and the like. The first memory 301 can include a flash memory. The second memory 302 can include a static random-access memory (SRAM).

The host system 200 can be implemented as an application processor (AP). The host system 200 can transmit the pixel data of the input image to the driver IC 300 through a mobile industry processor interface (MIPI). The host system 200 can be connected to the driver IC 300 through for example, a flexible printed circuit (FPC).

Meanwhile, the display panel can be implemented as a flexible panel applicable to a flexible display. The flexible display can have a screen that is variable in size by rolling, folding, or bending the flexible panel and can be easily manufactured with various designs.

The flexible display can be implemented as a rollable display, a foldable display, a bendable display, a slidable display, or the like.

The flexible panel can be manufactured as a so-called "plastic OLED panel." The plastic OLED panel can include a back plate and a pixel array formed on an organic thin film adhered to the back plate. A touch sensor array can be formed on the pixel array.

The back plate can be a polyethylene terephthalate (PET) substrate. The pixel array and the touch sensor array can be formed on the organic thin film. The back plate can block the permeation of moisture to the organic thin film so that the pixel array is not exposed to moisture.

The organic thin film can be a polyimide (PI) substrate. A multilayer buffer film can be formed of an insulating material on the organic thin film. A circuit layer 12 and an element layer 14 can be stacked on the organic thin film.

In the display device of the present disclosure, the pixel circuit and the gate driving unit disposed on the circuit layer 12 can include a plurality of transistors. The transistors can be implemented as oxide TFTs including an oxide semiconductor, low-temperature polysilicon (LTPS) TFTs including LTPS, and the like. Each of the transistors can be implemented as a p-channel TFT or an n-channel TFT. The following embodiments will be described focusing on an example in which the transistors of the pixel circuit are implemented as p-channel TFTs, but the present disclosure is not limited thereto.

The transistors are three-electrode elements including a gate, a source, and a drain. The source is an electrode that provides carriers to the transistor. The carriers in the transistor can start to flow from the source. The drain is an electrode through which the carriers are discharged from the transistor to the outside.

In the transistor, carriers flow from the source to the drain. In the situation of an n-channel transistor, carriers are electrons, and thus a source voltage is lower than a drain voltage so that the electrons flow from the source to the drain. In the n-channel transistor, current flows from the drain to the source.

In the situation of a p-channel transistor (PMOS), carriers are holes, and thus a source voltage is higher than a drain voltage so that the holes flow from the source to the drain. In the p-channel transistor, since the holes flow from the source to the drain, current flows from the source to the drain. It should be noted that the source and the drain of the transistor are not fixed in position. For example, the source and the drain are interchangeable depending on the applied voltage. Accordingly, the present disclosure is not limited by the source and the drain of the transistor. In the following description, the source and the drain of the transistor will be referred to as a first electrode and a second electrode.

A gate pulse can swing between a gate-on voltage and a gate-off voltage. The gate-on voltage can be set to be higher than a threshold voltage of the transistor, and the gate-off voltage can be set to be lower than the threshold voltage of the transistor.

The transistor can be turned on in response to the gate-on voltage and turned off in response to the gate-off voltage. In the situation of an n-channel transistor, the gate-on voltage can be a gate-high voltage VGH, and the gate-off voltage can be a gate-low voltage VGL. In the situation of a p-channel transistor, the gate-on voltage can be a gate-low voltage VGL, and the gate-off voltage can be a gate-high voltage VGH.

The driving element of the pixel circuit can be implemented as a transistor. The driving element should have uniform electrical characteristics between all the pixels, but there can be differences in electrical characteristics between the pixels due to a process variation and an element characteristic variation, and the electrical characteristics can vary as a display driving time passes.

In order to compensate for the electrical characteristic variation of the driving element, the display device can include an internal compensation circuit and an external compensation circuit. The internal compensation circuit can be added to the pixel circuit in each of the sub-pixels to sample a threshold voltage Vth and/or a mobility µ of the driving element, which vary according to the electrical characteristics of the driving element, and compensate for the variation in real time.

The external compensation circuit can transmit the threshold voltage and/or mobility of the driving element, which are sensed through the sensing line connected to each of the sub-pixels, to an external compensation unit. The compensation unit of the external compensation circuit can reflect the sensing result to modulate the pixel data of the input image, thereby compensating for the variation in the electrical characteristics of the driving element.

By sensing a voltage of the pixel, which varies according to electrical characteristics of an external compensation driving element, and modulating data of an input image in an external circuit based on the sensed voltage, it is possible to compensate for the variation in the electrical characteristics of the driving element between the pixels.

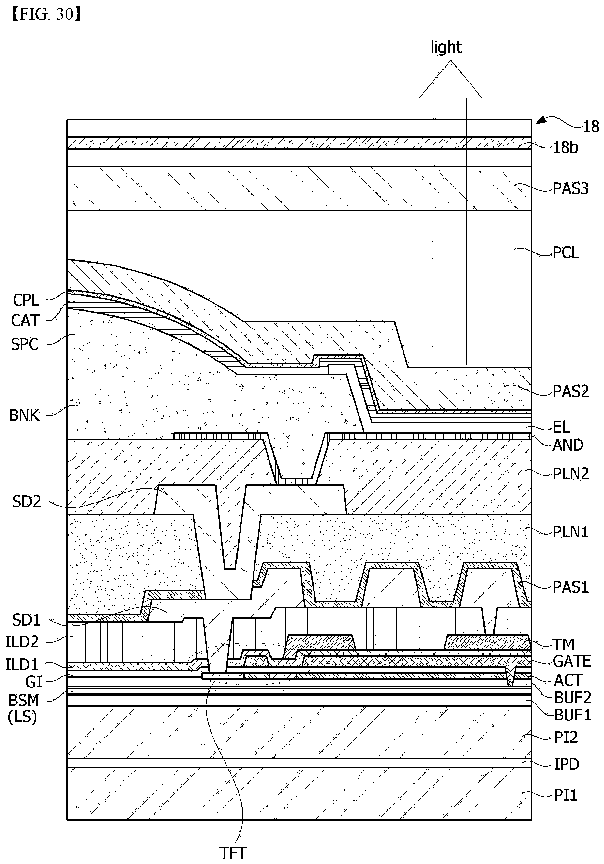

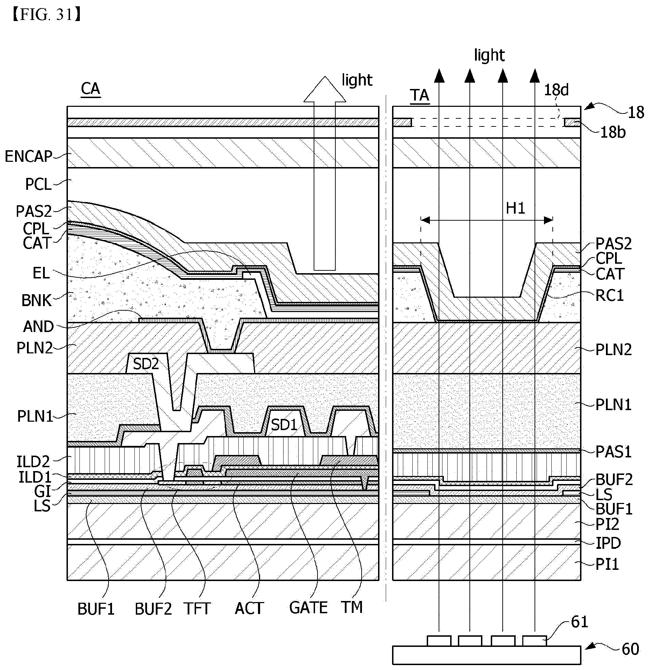

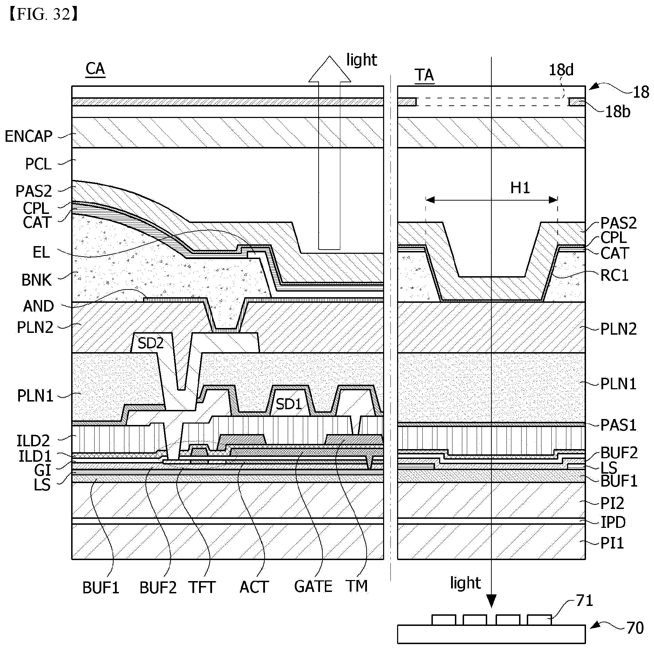

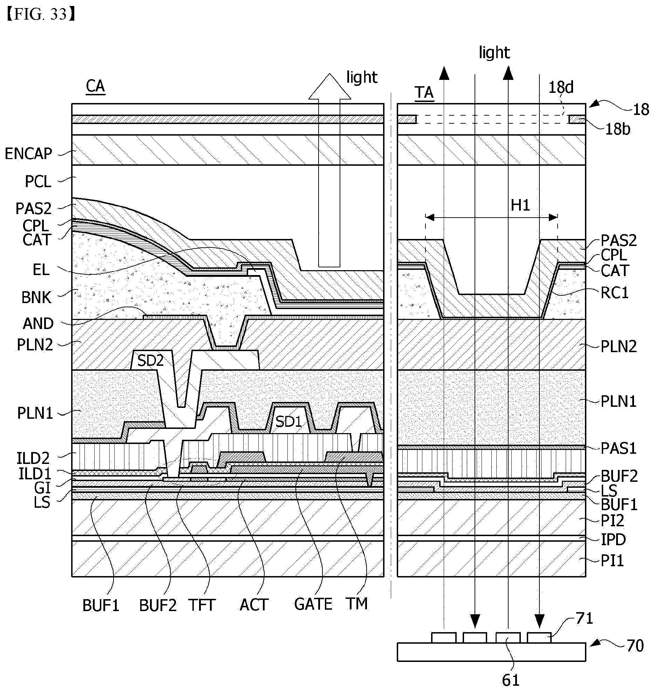

FIG. 30 is a cross-sectional view illustrating a cross-sectional structure of a pixel area in detail in a display panel according to one embodiment of the present disclosure. FIG. 31 illustrates a cross-sectional structure of the pixel area and a light-transmitting area according to one embodiment of the present disclosure. FIG. 32 is a first modified example of FIG. 31. FIG. 33 is a second modified example of FIG. 31.

In FIG. 30, "TFT" represents a driving element DT of the pixel circuit (e.g., a thin film transistor).

Referring to FIG. 30, a circuit layer, an element layer, and the like can be stacked on substrates PI1 and PI2 in a pixel area PIX. The substrates PI1 and PI2 can include a first PI substrate PI1 and a second PI substrate PI2. An inorganic film IPD can be formed between the first PI substrate PI1 and the second PI substrate PI2. The inorganic film IPD can block the penetration of moisture.

A first buffer layer BUF1 can be formed on the second PI substrate PI2. A first metal layer can be formed on the first buffer layer BUF1, and a second buffer layer BUF2 can be formed on the first metal layer.

The first metal layer can be patterned by a photolithography process. The first metal layer can include a light shield pattern BSM. The light shield pattern BSM can block external light so that the light is not irradiated to an active layer of a TFT, thereby preventing a photo current of the TFT formed in the pixel area from generating.

When the light shield pattern BSM is formed of a metal having a low absorption coefficient of a laser wavelength used in a laser ablation process as compared to a metal layer (e.g., a cathode) to be removed from the second display area CA, the light shield pattern BSM can also serve as a light shield layer LS configured to block a laser beam LB in the laser ablation process.

Each of the first and second buffer layers BUF1 and BUF2 can be made of an inorganic insulating material and can be formed of one or more insulating layers.

An active layer ACT can be made of a semiconductor material deposited on the second buffer layer BUF2 and can be patterned by a photolithography process. The active layer ACT can include an active pattern of each of TFTs of the pixel circuit and TFTs of the gate driving unit. A portion of the active layer ACT can be metallized by ion doping. The metallized portion can be used as a jumper pattern connecting the metal layers at some nodes of the pixel circuit to connect components of the pixel circuit.

A gate insulating layer GI can be formed on the second buffer layer BUF2 to cover the active layer ACT. The gate insulating layer GI can be made of an inorganic insulating material.

A second metal layer can be formed on the gate insulating layer GI. The second metal layer can be patterned by a photolithography process. The second metal layer can include a gate line, a gate electrode pattern GATE, a lower electrode of a storage capacitor Cst1, a jumper pattern connecting patterns of the first metal layer and a third metal layer, and the like.

A first interlayer insulating layer ILD1 can be formed on the gate insulating layer GI to cover the second metal layer. The third metal layer can be formed on the first interlayer insulating layer ILD1, and a second interlayer insulating layer ILD2 can cover the third metal layer. The third metal layer can be patterned by a photolithography process. The third metal layer can include metal patterns TM, such as an upper electrode of the storage capacitor Cst1. The first and second interlayer insulating layers ILD1 and ILD2 can each include an inorganic insulating material.

A fourth metal layer can be formed on the second interlayer insulating layer ILD2, and an inorganic insulating layer PAS1 and a first planarization layer PLN1 can be stacked on the fourth metal layer. A fifth metal layer can be formed on the first planarization layer PLN1.

Some patterns of the fourth metal layer can be connected to the third metal layer through a contact hole passing through the first planarization layer PLN1 and the inorganic insulating layer PAS1. The first and second planarization layers PLN1 and PLN2 can each be made of an organic insulating material enabling surfaces thereof to be flat.

The fourth metal layer can include first and second electrodes of a TFT connected to an active pattern of the TFT through a contact hole passing through the second interlayer insulating layer ILD2. The data line DL and the power lines can be implemented using a pattern SD1 of the fourth metal layer or a pattern SD2 of the fifth metal layer.

An anode AND, which is a first electrode layer of the light-emitting element OLED, can be formed on the second planarization layer PLN2. The anode AND can be connected to an electrode of a TFT used as the switch element or the driving element through a contact hole passing through the second planarization layer PLN2. The anode AND can be made of a transparent or semitransparent electrode material.

A pixel-defining film BNK can cover the anode AND of the light-emitting element OLED. The pixel-defining film BNK can be formed in a pattern that defines an emission area (or an opening area) through which light passes to the outside from each of the pixels. A spacer SPC can be formed on the pixel-defining film BNK. The pixel-defining film BNK and the spacer SPC can be integrated with the same organic insulating material. The spacer SPC can ensure a gap between a fine metal mask (FMM) and the anode AND so that the FMM is not in contact with the anode AND in a deposition process of an organic compound EL.

The organic compound EL can be formed in the emission area of each of the pixels, which is defined by the pixel-defining film BNK. A cathode CAT, which is a second electrode layer of the light-emitting element OLED, can be formed on the entire surface of a display panel 100 to cover the pixel-defining film BNK, the spacer SPC, and the organic compound EL. The cathode CAT can be connected to a VSS line PL3 formed of any one of the metal layers therebelow. A capping layer CPL can cover the cathode CAT. The capping layer CPL can be made of an inorganic insulating material to block the penetration of the air and out-gassing from the organic insulating material, which is applied on the capping layer CPL, to protect the cathode CAT. An inorganic insulating layer PAS2 can cover the capping layer CPL, and the planarization layer PCL can be formed on the inorganic insulating layer PAS2. The planarization layer PCL can include an organic insulating material. An inorganic insulating layer PAS3 of the encapsulation layer can be formed on the planarization layer PCL.

The polarizing plate 18 can be disposed on the inorganic insulating layer PAS3 to improve the outdoor visibility of the display device. The polarizing plate 18 can reduce the reflection of light from a surface of the display panel 100 and block the light reflected from metal of the circuit layer 12, thereby improving the brightness of the pixels.

Referring to FIG. 31, in a light-transmitting area TA, a first light-transmitting pattern 18d can be formed in the polarizing plate 18. The first light-transmitting pattern 18d can be formed by discoloring the polarizer 18b using a laser, or the first light-transmitting pattern 18d can be formed by partially removing portions of the polarizer 18b.

In the light-transmitting area TA, an opening HI can be formed in the cathode CAT (e.g., one or more holes for better transmitting light through the cathode CAT). The opening HI can be formed by forming the cathode CAT on the pixel-defining film BNK and then etching the cathode CAT and the pixel-defining film BNK at once. Accordingly, a first groove RC1 can be formed in the pixel-defining film BNK, and the opening HI of the cathode CAT can be formed on the first groove RC1. However, the present disclosure is not necessarily limited thereto, and the cathode CAT can be disposed on the second planarization layer PLN2 without forming the pixel-defining film in the light-transmitting area TA. Also, the cathode CAT can be formed of a transparent material or include transparent portions (e.g., over the light-emitting elements 61 or the light-receiving elements 71).

In the light-transmitting area TA, the first light-transmitting pattern 18d is formed in the polarizing plate 18, and the opening HI is formed in the cathode so that light transmittance can be improved. Accordingly, light emitted from a plurality of light-emitting elements 61 can be effectively emitted to the outside so that a dot image can be implemented. In addition, when a plurality of light-receiving elements 71 are disposed in the light-transmitting area TA as shown in FIG. 32, reflected light can be sufficiently introduced into the plurality of light-receiving elements 71 to acquire light data sufficient to generate a three-dimensional feature map. Referring to FIG. 33, when the plurality of light-emitting elements 61 and the plurality of light-receiving elements 71 are disposed in the light-transmitting area TA, light emitted from the light-emitting element 61 can be effectively emitted to the outside to implement a dot image, and reflected light can be sufficiently introduced into the plurality of light-receiving elements 71 to acquire light data sufficient to generate a three-dimensional feature map.

According to an embodiment, an electronic component is divided into a plurality of pieces and thus miniaturized, and distributed and disposed on or within a panel so that an area of a display area can be expanded.

Effects of the present disclosure will not be limited to the above-mentioned effects and other unmentioned effects will be clearly understood by those skilled in the art from the following claims.
The disclosure comprises the following items:
1. A display panel for a display device, the display panel comprising:
   a plurality of subpixels disposed on a substrate and configured to display an image;
   one or more light-emitting elements disposed on the substrate and configured to emit light; and
   one or more light-receiving elements disposed on the substrate and configured to receive reflected light based on the light emitted by the one or more light-emitting elements,
   wherein the one or more light-emitting elements or the one or more light-receiving elements are disposed between the plurality of subpixels.
2. The display panel of item 1, wherein the light emitted by the one or more light-emitting elements is infrared laser light.
3. The display panel of item 1 or item 2, wherein the one or more light-receiving elements are configured to generate a three-dimensional map for recognizing a face of a user based on the infrared laser light emitted by the one or more light-emitting elements.
4. The display panel of any preceding item, wherein the one or more light-emitting elements and the one or more light-receiving elements are disposed between the plurality of subpixels.
5. The display panel of any preceding item, wherein the one or more light-emitting elements or the one or more light-receiving elements are disposed on a same layer as the plurality of subpixels.
6. The display panel of any preceding item, wherein the one or more light-emitting elements or the one or more light-receiving elements are disposed on a different layer than the plurality of subpixels.
7. The display panel of any preceding item, further comprising:
   a first display area including a first portion of the plurality of subpixels;
   a second display area including a second portion of the plurality of subpixels,
   wherein the one or more light-emitting elements or the one or more light-receiving elements are only included in the second display area and are absent from the first display area.
8. The display panel of any preceding item, wherein the first portion of the plurality of subpixels in the first display area has a density that is different than a density of the second portion of the plurality of subpixels in the second display area.
9. The display panel of any preceding item, wherein the first portion of the plurality of subpixels in the first display area has a density that is same as a density of the second portion of the plurality of subpixels in the second display area.
10. The display panel of any preceding item, wherein at least some of the plurality of subpixels in the second display area have a size that is smaller than all pixels in the first display area.
11. The display panel of any preceding item, further comprising:
   at least one diffraction pattern disposed over the one or more light-emitting elements.
12. The display panel of any preceding item, further comprising:
   at least one first lens disposed over the one or more light-emitting elements,
   wherein the at least one first lens is disposed between the at least one diffraction pattern and the one or more light-emitting elements.
13. The display panel of any preceding item, wherein the one or more light-emitting elements are disposed under the substrate, and
   wherein the plurality of subpixels are disposed between at least one diffraction pattern and the one or more light-emitting elements.
14. The display panel of any preceding item, further comprising:
   at least one second lens disposed over the one or more light-receiving elements.
15. The display panel of any preceding item, wherein the at least one second lens includes at least two second lenses shifted in opposite directions relative to corresponding ones of the one or more light-receiving elements for adjusting a focus of the one or more light-receiving elements.
16. The display panel of any preceding item, wherein the one or more light-emitting elements or the one or more light-receiving elements are disposed in a grid arrangement or an array arrangement.
17. The display panel of any preceding item, wherein the one or more light-emitting elements are disposed in a first area of the display panel, and
   wherein the one or more light-receiving elements are disposed in a second area of the display panel spaced apart from the first area of the display panel.
18. The display panel of any preceding item, wherein the one or more light-emitting elements and the one or more light-receiving elements are alternatingly disposed throughout the display panel.
19. The display panel of any preceding item, further comprising:
   an anode and a cathode, each of the plurality of subpixels being connected between the anode and the cathode,
   wherein the one or more light-emitting elements or the one or more light-receiving elements are disposed under one or more holes in the cathode.
20. The display panel of any preceding item, wherein the light emitted by the one or more light-emitting elements passes through a diffraction pattern and is divided into a zero-order beam and a first-order beam,
   wherein the one or more light-receiving elements are configured to receive the first-order beam, and
   wherein a diffraction ratio of the zero-order beam and the first-order beam is in a range of 1:2 to 1:7.

## Claims

1. A display panel for a display device, the display panel comprising:
a plurality of subpixels disposed on a substrate and configured to display an image;
one or more light-emitting elements disposed on the substrate and configured to emit light; and
one or more light-receiving elements disposed on the substrate and configured to receive reflected light based on the light emitted by the one or more light-emitting elements,
wherein the one or more light-emitting elements or the one or more light-receiving elements are disposed between subpixels of the plurality of subpixels.

2. The display panel of claim 1, wherein the light emitted by the one or more light-emitting elements is infrared laser light.

3. The display panel of claim 2, wherein the one or more light-receiving elements are configured to generate a three-dimensional map for recognizing a face of a user based on the infrared laser light emitted by the one or more light-emitting elements.

4. The display panel of any preceding claim, wherein the one or more light-emitting elements and the one or more light-receiving elements are disposed between subpixels of the plurality of subpixels.

5. The display panel of any preceding claim, wherein:
the one or more light-emitting elements or the one or more light-receiving elements are disposed on a same layer as the plurality of subpixels; or
the one or more light-emitting elements or the one or more light-receiving elements are disposed on a different layer than the plurality of subpixels.

6. The display panel of any preceding claim, further comprising:
a first display area including a first portion of the plurality of subpixels; and
a second display area including a second portion of the plurality of subpixels,
wherein the one or more light-emitting elements or the one or more light-receiving elements are only included in the second display area and are absent from the first display area.

7. The display panel of claim 6, wherein the first portion of the plurality of subpixels in the first display area has a density that is different than a density of the second portion of the plurality of subpixels in the second display area.

8. The display panel of claim 6, wherein the first portion of the plurality of subpixels in the first display area has a density that is the same as a density of the second portion of the plurality of subpixels in the second display area, and optionally wherein at least some of the plurality of subpixels in the second display area have a size that is smaller than all pixels in the first display area.

9. The display panel of any preceding claim, further comprising:
at least one diffraction pattern disposed over the one or more light-emitting elements; and optionally further comprising:
at least one first lens disposed over the one or more light-emitting elements,
wherein the at least one first lens is disposed between the at least one diffraction pattern and the one or more light-emitting elements.

10. The display panel of claim 1, wherein the one or more light-emitting elements are disposed under the substrate, and
wherein the plurality of subpixels are disposed between at least one diffraction pattern and the one or more light-emitting elements.

11. The display panel of any preceding claim, further comprising:
at least one second lens disposed over the one or more light-receiving elements; and optionally wherein the at least one second lens includes at least two second lenses shifted in opposite directions relative to corresponding ones of the one or more light-receiving elements for adjusting a focus of the one or more light-receiving elements.

12. The display panel of any preceding claim, wherein the one or more light-emitting elements or the one or more light-receiving elements are disposed in a grid arrangement or an array arrangement.

13. The display panel of any preceding claim, wherein:
the one or more light-emitting elements are disposed in a first area of the display panel, and the one or more light-receiving elements are disposed in a second area of the display panel spaced apart from the first area of the display panel; or
the one or more light-emitting elements and the one or more light-receiving elements are alternatingly disposed throughout the display panel.

14. The display panel of any preceding claim, further comprising:
an anode and a cathode, each of the plurality of subpixels being connected between the anode and the cathode,
wherein the one or more light-emitting elements or the one or more light-receiving elements are disposed under one or more holes in the cathode.

15. The display panel of any of claims 1-8, wherein the light emitted by the one or more light-emitting elements passes through a diffraction pattern and is divided into a zero-order beam and a first-order beam,
wherein the one or more light-receiving elements are configured to receive the first-order beam, and
wherein a diffraction ratio of the zero-order beam and the first-order beam is in a range of 1:2 to 1:7.
